# EUROPEAN PATENT APPLICATION

(11) **EP 1 870 917 A1**
(43) Date of publication of application: **26.12.2007**
(21) Application number: 06731075.5
(22) Date of filing: 04.04.2006
(51) Int. Cl.: H01H 35/00, E05B 1/00, E05B 49/00, H01H 36/00, H01L 41/08, H01L 41/113

(54) **CONTACT DETECTION DEVICE, AND DOOR HANDLE DEVICE AND SMART ENTRY SYSTEM WITH THE SAME**

(30) Priority: 14.04.2005 JP 2005116829; 02.11.2005 JP 2005319042; 31.01.2006 JP 2006022051; 28.03.2006 JP 2006089002
(71) Applicant: MATSUSHITA ELECTRIC INDUSTRIAL CO., LTD., Osaka 571-8501 (JP)
(72) Inventor: KONDOU, Ryuta c/o Matsushita Electr.Ind.Co.Ltd. IPROC, IP Dev.Cent., Chuo-ko, Osaka 540-6207 (JP); ABE, Yukio c/o Matsushita Electr.Ind.Co.Ltd., IPROC, IP Dev.Cent., Chuo-ku, Osaka 540-6207 (JP); OGINO, Hiroyuki c/o Matsushita Electr.Ind.Co.Ltd., IPROC, IP Dev.Cent., Chuo-ku, Osaka 540-6207 (JP); SHIRAI, Shigeru c/o Matsushita Electr.Ind.Co.Ltd., IPROC, IP Dev.Cent., Osaka 540-6207 (JP); YONENO, Noriyuki c/o Matsushita Electr.Ind.Co.Ltd., IPROC, IP Dev.Cent., Osaka 540-6207 (JP); KAWAI, Miyuki c/o Matsushita Electr.Ind.Co.Ltd., IPROC, IP Dev.Cent., Osaka 540-6207 (JP); INUI, Hirofumi c/o Matsushita Electr.Ind.Co.,Ltd., IPROC, IP Dev.Cent., Osaka 540-6207 (JP)
(74) Representative: Grünecker, Kinkeldey, Stockmair & Schwanhäusser Anwaltssozietät
(86) International application number: PCT/JP2006/307127
(87) International publication number: WO 2006/112258

(57) **Abstract**

As a switch for detecting operation of a door handle, a contact joint switch, a capacitance type sensor, etc., is available, but involves problems of a contact failure caused by secular change and a malfunction caused by rain and is not excellent in a multifunctional property used for other applications.

A contact detector of the invention includes support means (8) having a moving part displacing upon reception of contact; a cable-like piezoelectric sensor (4).having a part supported by the support means (8) and becoming deformed in conjunction with displacement of the moving part (8c); and signal processing means for performing signal processing of output of the cable-like piezoelectric sensor (8), wherein the cable-like piezoelectric sensor (8) has a bend part (4a) to form a plurality of simultaneous deformation parts and the simultaneous deformation parts become deformed in conjunction with the moving part (8c), whereby contact is detected.

## Description

### Technical Field

This invention relates to a handle unit including a door handle and a contact detector provided with a sensor for detecting operation of the handle unit.

### Background Art

To unlock a door by operating a door handle of a vehicle, a unit is provided with a function of releasing door lock under a predetermined condition when a detection signal is output from a sensor for detecting contact with the door handle or operation of the door handle. The contact mentioned here refers mainly to contact with the door handle in the push direction of the door handle or the pulling direction and further in the early stage of the pulling operation for the purpose of door opening/closing operation.

As a sensor in a related art for detecting contact with the door handle or operation of the door handle, for example, patent document 1 discloses a vehicle door handle unit for releasing door lock using a contact joint switch such as a membrane switch for the sensor. The membrane switch is of a well-known structure; a pair of electrode parts placed with a predetermined spacing is printed on the opposed internal faces of a pair of flexible film plates placed facing each other through a spacer. The membrane switch is normally in an off state and as an elastic body of silicon rubber, etc., placed on one plate so as to be positioned on the electrode part is pressed by a trigger, the electrodes come in contact with each other, whereby the membrane switch is placed in an on state.

Patent document 2 discloses a human body approach detection sensor for an automobile for releasing door lock using a capacitance type sensor. An outer handle using the human body approach detection sensor for an automobile is formed as a hollow shape and a parallel cable forming the capacitance type sensor as a noncontact sensor is received in the hollow portion so as to extend along the length direction of a grip part of the outer handle. The parallel cable is joined to a shield line provided so that a base end part extends to the outside through an opening made in the proximity of a pivot part of the outer handle and an opposite end of the shield line is connected to a circuit board.

By the way, in recent years, a keyless entry apparatus for releasing door lock using a card, a transmitter, etc., for personal identification without inserting a key into a key hole for a general door lock release method for releasing door lock by inserting a key into a key hole of a door handle has been applied to a door of an automobile, a house, etc. This kind of radio wave lock apparatus for a vehicle is disclosed in patent document 3. In the radio wave lock apparatus for a vehicle, while a control section is operated as a door handle of a vehicle is pulled, a portable transceiver is placed in a transmission state by receiving a transmission-reception code from a transmitter of the vehicle and the control section performs release processing based on a unique code from the portable transceiver. Detection means for detecting the door handle being pulled is provided and a transmission-reception code is transmitted from the transmitter of the vehicle based on a detection signal from the detection means.
Patent document 1: JP-A-2002-322834
Patent document 2: JP-A-10-308149
Patent document 3: JP-A-8-53964

### Disclosure of the Invention

### Problems to be Solved by the Invention

However, the contact joint switch used with the door handle unit in the related art described above involves a contact failure caused by secular change and a defect of not operating with light touch of contact only, etc. Since a stroke to contact joint exists, a time lag from the touch instant to operation of the switch inevitably occurs, causing response to be worsened. For example, when a door handle is gripped and is pulled, if the door is pulled abruptly, release of lock means is late and the lock state remains or looseness occurs. Thus, the door handle is gripped and is pulled after wait for a predetermined time, namely, operation feeling is adversely affected.

On the other hand, the capacitance type sensor involves a problem of a malfunction if a door handle becomes wet because of rainfall or carwash and a problem of no operation although the user touches a door handle if he or she wears a glove. Since capacitance varies from one person to another and also changes depending on worn shoes, it is extremely difficult to adjust sensitivity; this is also a problem.

Preferably, a piezoelectric sensor is used as a contact switch capable of enhancing detection sensitivity, separating from a noise component, and being switched on and off with a touch feeling reacting with a slight touch only.

However, a general piezoelectric sensor is a rigid body of an arrangement of piezoelectric elements made of ceramics, etc., and if there is a restriction on the placement area of the sensor, the piezoelectric sensor cannot be placed and cannot be incorporated in any desired location; this is a problem.

It is also possible to use an optical sensor of a noncontact type, but the optical sensor is not practical because a malfunction often occurs due to dust deposited on the sensor, weather conditions of rain, snow, etc., and the like.

From such circumstances, in a door handle unit using the contact joint switch, the capacitance type sensor, the general piezoelectric sensor, or the optical sensor or a keyless entry apparatus including the door handle unit, it is difficult to realize good operation feeling, operation reliability, and incorporating property.

It is therefore an object of the invention to provide a contact detector using a piezoelectric sensor having a flexible structure and being capable of providing sufficient detection sensitivity even with light touch and a door handle unit including the contact detector for detecting opening/closing operation.

### Means for Solving the Problems

To solve the problems in the related arts described above, a contact detector of the invention includes support means having a moving part displacing upon reception of contact; a piezoelectric sensor having a part supported by the support means and becoming deformed in conjunction with displacement of the moving part; and signal processing means for performing signal processing of output of the piezoelectric sensor, characterized in that the piezoelectric sensor has a bend part to form a plurality of simultaneous deformation parts and the simultaneous deformation parts become deformed in conjunction with the moving part, whereby contact is detected.

Accordingly, it is made possible for the piezoelectric sensor to have flexibility and be attached to a door handle, etc. As displacement of the moving part is detected, when minute displacement at the contact time of a person or an object is detected, it.is detected according to simultaneous deformation of a plurality of parts of the piezoelectric sensor, so that detection with higher sensitivity and higher output is made possible.

### Advantages of the Invention

In the contact detector of the invention, it is made possible for the piezoelectric sensor to have flexibility and be attached to a door handle, etc. As displacement of the moving part is detected, when minute displacement at the contact time of a person or an object is detected, it is detected according to a signal produced by simultaneous deformation of a plurality of parts of the piezoelectric sensor, so that detection with higher sensitivity and higher output is made possible. Therefore, sufficient signal output is obtained as a person simply touches the contact detection target of a door handle, etc., and it is made possible to detect touch on the contact detection target. Since the electrode need not be exposed, the effect of disturbance and deposited dust, rain, snow, etc., is hard to receive. Further, the piezoelectric sensor can become flexibly deformed and thus the number of restrictions on the installation place is small and the placement space also lessens.

### Brief Description of the Drawings

FIG. 1 is an external view of an automobile door including a door handle unit including a contact detector in a first embodiment of the invention.
FIG 2 is an external view of a handle bracket 2 when it is viewed from the car outside in the first embodiment of the invention.
FIG 3 is an external view of the handle bracket 2 when it is viewed from the car inside in the first embodiment of the invention.
FIG 4 is a sectional view of a piezoelectric sensor 4 in the first embodiment of the invention.
FIG. 5 is a schematic drawing to show displacement of a doorknob 3, the piezoelectric sensor 4, an elastic body 8, and an arm part 9 at the operation time of the doorknob 3.
FIG. 6 is a schematic drawing of viewing FIG. 5 from S direction. FIG. 7 is a characteristic drawing to show signal V amplified and filtered in detection means and determination output J of a determination section in the first embodiment of the invention.
FIG 8(a) is an external view of a handle bracket 2 when it is viewed from the car inside in a second embodiment of the invention and FIG. 8(b) is a schematic drawing of viewing FIG. 8(a) from S direction.
FIG. 9(a) is a schematic drawing to show displacement of a doorknob 3, a piezoelectric sensor 4, an elastic body 8, and an arm part 9 at the operation time of the doorknob 3 of the handle bracket 2 in the second embodiment of the invention, and FIG. 9(b) is a schematic drawing of viewing FIG. 9(a) from S direction.
FIG 10 is an external view of a handle bracket 2 in another embodiment of.the invention.
FIG 11 is an external view of an automobile door including a door handle unit including a contact detector in a third embodiment of the invention.
FIG 12 is an external view of a handle bracket 1002 when it is viewed from the car outside in the third embodiment of the invention.
FIG 13 is an external view of the handle bracket 1002 when it is viewed from the car inside in the third embodiment of the invention.
FIG 14 is an enlarged perspective view of the main part of the handle bracket in the third embodiment of the invention.
FIG 15A is a sectional view of a piezoelectric sensor 1004 in the third embodiment of the invention.
FIG. 15B is a sectional view of a modified example of the piezoelectric sensor 1004 (eccentric structure).
FIG. 15C is a sectional view of a modified example of the piezoelectric sensor 1004 (rectangle).
FIG 15D is a drawing to show the turn shape of tape-like piezoelectric sensor.
FIG. 15E is a sectional view of tape-like piezoelectric sensor.
FIG 15F is a sectional view of tape-like piezoelectric sensor of eccentric structure.
FIG 15G is an enlarged view of the main part of a bend part of piezoelectric sensor of eccentric structure.
FIG. 16 is a schematic drawing to show displacement of a door handle 1003, a piezoelectric sensor 1004, support means 1008, and an arm part 1010 at the operation time of the door handle 1003.
FIG. 17(a) is a schematic drawing of viewing FIG. 16 from S direction and FIG. 17(b) is a schematic drawing at the handle operation time in FIG. 17(a).
FIG. 18 is a characteristic drawing to show signal V amplified and filtered in detection means and determination output J of a determination section in the third embodiment of the invention.
FIG. 19 is a graph to show the relationship between the number of bend parts and output signal of the piezoelectric sensor of the contact detector in the third embodiment of the invention.
FIG 20(a) is an external view of a handle bracket 1002 when it is viewed from the car inside in a fourth embodiment of the invention and FIG. 20(b) is a schematic drawing of viewing FIG. 20(a) from S direction.
FIG. 21 is an enlarged external view of the main part of a handle bracket 1002 when it is viewed from the car inside in a fifth embodiment of the invention.
FIG. 22(a) is a drawing to describe another attachment structure of the fifth embodiment of the invention and FIG. 22(b) is a schematic drawing of viewing FIG. 22(a) from S direction.
FIG 23 is an enlarged external view of the main part of a handle bracket 1002 when it is viewed from the car inside in a sixth embodiment of the invention.
FIG. 24(a) is an external view of a handle bracket 1002 when it is viewed from the car inside in a seventh embodiment of the invention and FIG. 24(b) is a schematic drawing of viewing FIG. 24(a) from S direction.
FIG. 25 is an external perspective view of a door handle unit in an eighth embodiment of the invention.
FIG 26 is an external view of a handle bracket when it is viewed from the car inside in the eighth embodiment of the invention.
FIG. 27(a) is an external view of viewing the eighth embodiment from z direction in FIG. 26 when a handle is at a usual position and FIG. 27(b) is an external view of viewing the eighth embodiment from z direction in FIG. 26 when the handle is pulled in b direction in FIG. 27.
FIG 28A is a drawing to show a modified example of a wind shape portion of a piezoelectric sensor 1004.
FIG 28B is an enlarged view of the main part of the modified example of the wind shape portion of the piezoelectric sensor 1004.
FIG. 29 is a drawing to show an application example to a handle of another configuration.
FIG 30(a) is an external perspective view of a contact detector of the eighth embodiment and FIG. 30(b) is a front view of the eighth embodiment.

### Description of Reference Numerals

- 1: Door
- 3: Doorknob
- 4: Piezoelectric sensor
- 4a: Bend part
- 5: Detection means
- 8: Elastic body
- 8a: Fix part
- 8b: Support part
- 9: Arm part
- 9a: Upper end
- 9b: Fix shaft
- 500: Sensor unit
- 1001: Door
- 1003: Door handle
- 1004: Piezoelectric sensor
- 1004a: Bend part
- 1005: Detection means (signal processing means)
- 1008: Support means
- 1008a: Fix part
- 1008b: Support part
- 1009: Multilayer superposition part
- 1010: Arm part
- 1012: Spring (elastic joint means)
- 1014: Hook part (connection part)
- 1015: Controlling spring (joint means)
- A: Simultaneous deformation part

### Best Mode for Carrying out the Invention

A first aspect of the invention includes support means having a moving part displacing upon reception of contact; a piezoelectric sensor having a part supported by the support means and becoming deformed in conjunction with displacement of the moving part; and signal processing means for performing signal processing of output of the piezoelectric sensor, wherein the piezoelectric sensor has a bend part to form a plurality of simultaneous deformation parts and the simultaneous deformation parts become deformed in conjunction with the moving part, whereby contact is detected.

According to the configuration, it is made possible for the piezoelectric sensor to have flexibility and be attached to a door handle, etc. As displacement of the moving part is detected, when minute displacement at the contact time of a person or an object is detected, it is detected according to simultaneous deformation of a plurality of parts of the piezoelectric sensor, so that detection with higher sensitivity and higher output is made possible, Therefore, sufficient signal output is obtained as a person simply touches the contact detection target and it is made possible to detect touch on the contact detection target. Since the electrode need not be exposed, the effect of disturbance and deposited dust, rain, snow, etc., is hard to receive. Further, the piezoelectric sensor can become flexibly deformed and thus the number of restrictions on the installation place is small and the placement space also lessens.

In a second aspect of the invention, particularly in the first aspect of the invention, the displacement amount of the moving part of the support means has a predetermined upper limit value, and if the displacement of the moving part becomes the predetermined upper limit value or more, displacement is suppressed.

According to the configuration, since the moving range of the moving part is limited, the deformation width of the piezoelectric sensor is also limited. Thus, to obtain output of the sensor, the sensor is not deformed more than necessary and the load on the sensor at the deformation time is also limited.

In a third aspect of the invention, particularly in the first or second aspect of the invention, the support means and the piezoelectric sensor are fixed by the signal processing means.

According to the configuration, the contact detector is formed in one piece, so that it becomes easy to attach to a. target of a door handle, etc.

A fourth aspect of the invention, particularly in any one of the first to third aspects of the invention, includes position regulation means of the piezoelectric sensor, wherein the moving part of the support means is provided with joint means made of an elastic body, whereby the moving part and the position regulation means are joined with elasticity and the simultaneous deformation parts are deformed with displacement of the moving part.

According to the configuration, pressure can be given for urging with the elasticity of the joint means so that the moving part is easy to displace if a person comes in contact with the contact target, so that it is made possible to perform stable operation independently of the elasticity of the piezoelectric sensor and contact detection of a person or an object based on detection of minute displacement can be made with good responsibility and with higher sensitivity and higher output and the reliability can be improved.

In a fifth aspect of the invention, particularly in any one of the first to third aspects of the invention, the support means is made of an elastic body and the simultaneous deformation parts are supported by the moving part, whereby the simultaneous deformation parts are deformed with displacement of the moving part.

According to the configuration, pressure can be given for urging with the elasticity of the joint means so that the moving part is easy to displace if a person comes in contact with the contact target, so that stable operation is made possible, contact detection can be made with good responsibility and with higher sensitivity and higher output, and the reliability can be improved.

In a sixth aspect of the invention, particularly in the fifth aspect of the invention, the support means has a fix part fixed at one end to a sensor unit including the support means, the piezoelectric sensor, and the signal processing means, is molded roughly like a plate shaped like a cantilever, and supports a part of the piezoelectric sensor in an extension direction to an opposite side to the fix part.

According to the configuration, a practical configuration for also deforming the piezoelectric sensor when the elastic body becomes deformed can be provided.

In a seventh aspect of the invention, particularly in the sixth aspect of the invention, the piezoelectric sensor includes the simultaneous deformation parts in the extension direction to the opposite side to the fix part.

According to the configuration, if the same displacement is received, an output signal for deformation of the bend part can be taken larger than that of a linear part, so that the sensitivity of the piezoelectric sensor improves.

In an eighth aspect of the invention, particularly in the seventh aspect of the invention, the signal processing means detects a signal of the piezoelectric sensor at the deformation time from a state in which the support means is urged under a predetermined stress.

According to the configuration, play does not occur in contact or displacement of the moving part of the support means and upon reception of contact, the moving part becomes deformed with good response, so that contact can be detected at high speed and with high sensitivity.

In a ninth aspect of the invention, particularly in any one of the first to eighth aspects of the invention, the simultaneous deformation parts are formed by turning the piezoelectric sensor at least one or more.

According to the configuration, if the same displacement is received, the bend part formed by turning the piezoelectric sensor at least one or more has a larger number of bend points than the bend part formed simply by making a U turn of the piezoelectric sensor and the charge generation amount based on the piezoelectric effect increases according to the number of the bend points and an output signal can be taken larger, so that the sensitivity of the piezoelectric sensor further improves.

In a tenth aspect of the invention, particularly in any one of the first to ninth aspects of the invention, the simultaneous deformation parts are formed by forming one piezoelectric sensor with a multilayer superposition part.

According to the configuration, when contact is detected, the multilayer superposition part formed by winding the piezoelectric sensor as multiple winding, etc., becomes deformed, whereby a plurality of parts of the piezoelectric sensor become deformed at the same time, so that detection with higher sensitivity and higher output is made possible. Therefore, sufficient signal output is obtained as a person simply touches the contact detection target and it is made possible to detect touch on the contact detection target. The simultaneous deformation parts are formed by the multilayer superposition part, whereby the structure becomes compact, the number of restrictions on the installation place is small, and the placement space also lessens.

In an eleventh aspect of the invention, particularly in the ninth or tenth aspect of the invention, the multilayer superposition part of the piezoelectric sensor is supported loosely.

According to the configuration, since the multilayer superposition part is in a loose fit state, easy deformation is possible, limitations on the deformation lessen, and the load on the sensor lessens.

In a twelfth aspect of the invention, particularly in any one of the first to eleventh aspects of the invention, the piezoelectric sensor includes a center electrode, a piezoelectric body, an outer electrode, and a coating layer with them coaxially formed in order and the outer electrode is formed of a braided metal wire.

According to the configuration, the flexibility of the piezoelectric sensor improves, so that it becomes easy to perform bending to form the simultaneous deformation part, degradation of flexibility and an output anomaly occurring from deformation of the outer electrode caused by bending are prevented, detection with high sensitivity and high output is realized stably, and the reliability can be improved.

In a thirteenth aspect of the invention, particularly in any one of the first to twelfth aspects of the invention, the piezoelectric sensor is of an eccentric structure wherein a center electrode is eccentric relative to a piezoelectric body, and is bent in a specific direction relative to the eccentric direction to form the simultaneous deformation parts.

According to the configuration, when the piezoelectric sensor is bent for use so that the center electrode becomes the outside, a large tension is put on the center electrode, so that large output is provided. In contrast, when the piezoelectric sensor is bent for use so that the center electrode becomes the inside, small output is provided on the center electrode.

In a fourteenth aspect of the invention, particularly in the thirteenth aspect of the invention, the piezoelectric sensor is rectangular in cross section as the cross-sectional shape of the outer shape.

According to the configuration, when the piezoelectric sensor is wound more than once to form a bend part, rectangular face portions are superposed on each other for formation, so that the arrangement becomes good.

In a fifteenth aspect of the invention, particularly in any one of the first to fourteenth aspects of the invention, a moving arm of a door handle is brought into contact with the moving part of the support means for attachment.

According to the configuration, the door handle unit is applied to a keyless entry apparatus or a smart entry apparatus in doors of a building, a front door, etc., and the operability of the door handle section of the apparatus improves; a door handle unit having multiple functions and excellent convenience can be realized.

A sixteenth aspect of the invention, particularly in the fifteenth aspect of the invention, includes a connection part for connecting the moving arm of the door handle and the moving part of the support means, wherein the connection state of the moving arm and the moving part is maintained by the connection part at least in the early stage of displacement of the moving arm in operation of the door handle.

According to the configuration, at least in the early stage of displacement of the moving arm in door handle operation, the connection state of the arm part and the moving part is maintained by the connection part, whereby if displacement of the moving arm occurs by door handle operation, the moving part is not detached and reliable displacement can be conducted, so that detection with high sensitivity and high output is realized stably and the reliability can be improved.

A seventeenth aspect of the invention is a smart entry system including the door handle unit in the fifteenth or sixteenth aspect of the invention.

According to the configuration, the door handle unit is applied to a smart entry system in doors of a side door, a tail gate, etc., and the operability of the door handle section of the smart entry system can be improved.

Embodiments of the invention will be di scussed with reference to the accompanying drawings. The invention is not limited to the embodiments.

### (First embodiment)

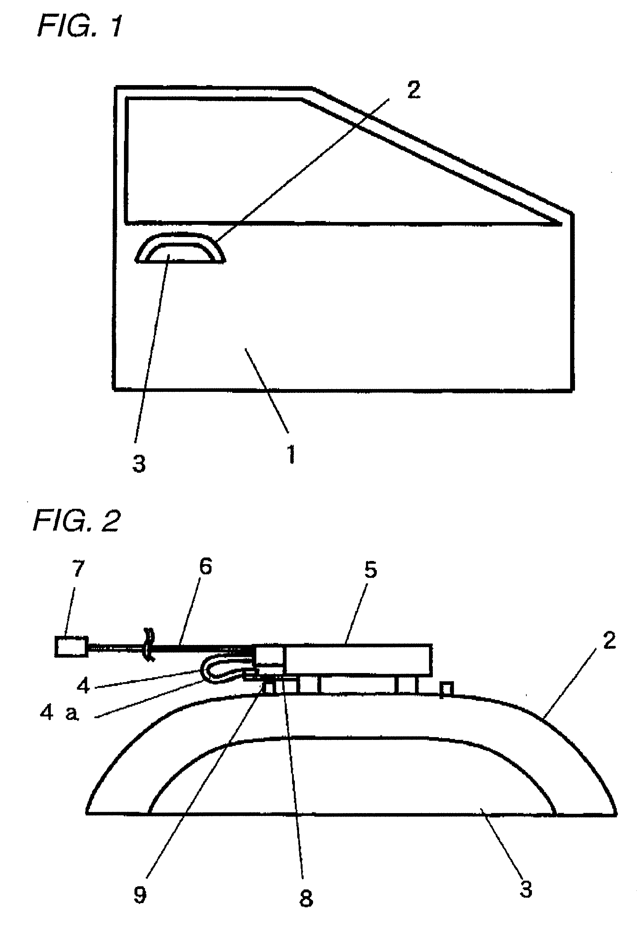

A first embodiment of the invention will be discussed with reference to FIGS. 1 to 7.

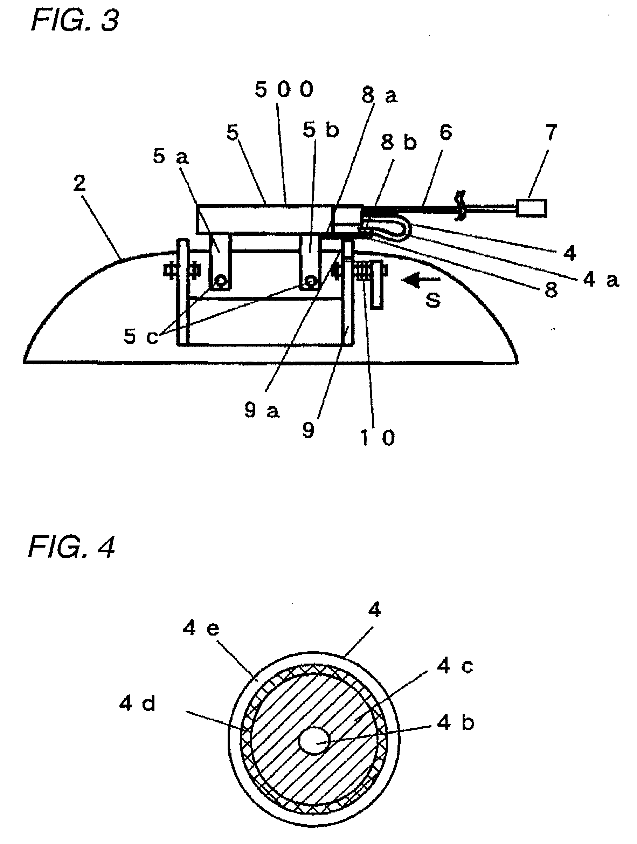

FIG. 1 is an external view of an automobile door including a door handle unit in a first embodiment of the invention. In the figure, a handle bracket 2 is attached to a door 1. The handle bracket 2 has a doorknob 3. FIG 2 is an external view of the handle bracket 2 when it is viewed from the car outside and FIG 3 is an external view of the handle bracket 2 when it is viewed from the car inside. In the figure, a piezoelectric sensor 4 shaped like a cable having flexibility is attached to the handle bracket 2 together with detection means 5. A cable 6 and a connector 7 for power supply and detection signal output are connected to the detection means 5. The piezoelectric sensor 4 is supported on and fixed to the tip of an elastic body 8 made of a leaf spring (support part 8b in the figure). The piezoelectric sensor 4 includes a bend part 4a in the extension direction from the tip side of the elastic body 8. The elastic body is fixed at an opposite end to the detection means 5 like a cantilever (8a in the figure). As shown in the figure, the support part 8b of the piezoelectric sensor 4, of the elastic body 8 and the fix part 8b of the elastic body 8 are provided at distant positions; in the embodiment, they are provided at both ends in the length direction like a plate. However, they need not necessarily be positioned at both ends and need only to be positioned at different places. The elastic body 8 is in contact with an arm part 9 operatively connected to the doorknob 3 at an upper end 9a. At this time, when the doorknob 3 is unused, the elastic body 8 is urged under a predetermined pressure and is in contact with the upper end 9a of the arm part. A predetermined spring pressure is applied to the arm part 9 by a spring 10, so that the doorknob 3 is pressed in the closed direction at all times.

The piezoelectric sensor 4, the elastic body 8, and the detection means 5 are molded in one piece to form a sensor unit 500, as shown in FIG 3. The sensor unit 500 is attached to the handle bracket 2 with screws 5c through mounting brackets 5a and 5b included in the detection means 5.

FIG. 4 is a sectional view of the piezoelectric sensor 4. The piezoelectric sensor 4 is provided by shaping a center electrode 4b, a piezoelectric body 4c, an outer electrode 4d, and a coating layer 4e coaxially; it has a structure excellent in flexibility as a whole. The center electrode 4b may use a usual metal solid conductor wire; here, an electrode having a metal coil wound on the circumference of insulating polymer fiber is used. Preferably, polyester fiber commercially used in an electric blanket and a copper alloy containing 5 wt% of silver are used as the insulating polymer fiber and the metal coil respectively.

The piezoelectric body 4c is provided by mixing and kneading polyethylene base resin and piezoelectric ceramic (here, lead titanate zirconate) powder; they are squeezed out continuously together with the center electrode 4b to form the piezoelectric body 4c having flexibility. As..the piezoelectric ceramic, preferably, non-lead base material, for example, piezoelectric ceramic material based on bismuth sodium titanate or niobate alkali is used from consideration for the environment.

After the piezoelectric body 4c is squeezed out on the circumference of the center electrode 4b, several k V DC voltage is applied between the center electrode 4b and a pseudo electrode brought into contact with the surface of the piezoelectric body 4c to perform polarization of the piezoelectric body 4c. Accordingly, the piezoelectric body 4c is provided with the piezoelectric effect. A strip electrode with a metal film adhered onto a polymer layer is wound around the circumference of the piezoelectric body 4c to form the outer electrode 4d. An electrode using polyethylene terephthalate (PET) as a polymer layer and having an aluminum film adhered thereonto has high thermal stability at 120°C and is also produced in quantity commercially and therefore is preferred as the outer electrode 4d. To shield from electric noise of the external environment, preferably the outer electrode 4d is wound around the circumference of the piezoelectric body 4c so as to partially overlap the piezoelectric body 4c. Although it is advisable to use polyvinyl chloride as the coating layer 4e from the reliability, preferably a non-polyvinyl chloride material such as a thermoplastic elastomer is used from consideration for the environment.

The detection means 5 includes at least one band pass filter section made up of an operational amplifier and a peripheral component and a band elimination filter section or a low-pass filter section made up of an operational amplifier and a peripheral component for eliminating a signal component containing a natural frequency of the door 1. It includes a determination section for detecting at least one of contact of an object with the doorknob 3 and the opening operation and the closing operation with the doorknob 3 based on an output signal of the filter section. A comparator is used as the determination section. Each of the filter section and the determination section uses an element of low current consumption type of 1 mA or less.

The band pass filter section is set so as to become a characteristic such that it allows a frequency domain of 3 Hz to 8 Hz, for example, to pass through as a feature frequency band by conducting frequency analysis of an output signal from the piezoelectric sensor 4 when the doorknob 3 is operated experimentally.

The band elimination filter section or the low-pass filter section is set so as to become a characteristic such that it eliminates a frequency domain of 10 Hz or more, for example, as a feature frequency band by conducting frequency analysis of an output signal from the piezoelectric sensor 4 when the door 1 is struck by intention, for example. If the strength of the natural frequency is small and the effect on the output signal of the piezoelectric sensor 4 is small, the band elimination filter section or the low-pass filter section need not be provided.

Further, since it is assumed that the natural frequency characteristic of a door varies depending on the car type, the size, the weight of the door, etc., preferably the settings of the band pass filter section and the band elimination filter section or the low-pass filter section are optimized based on experimental analysis as mentioned above.

To remove external electric noise, preferably the whole of the detection means 5 is covered with a shield member to electrically shield the detection means 5. A feedthrough capacitor, an EMI filter, etc., may be added to an input/output section of the detection means 5 to take measures against a strong field.

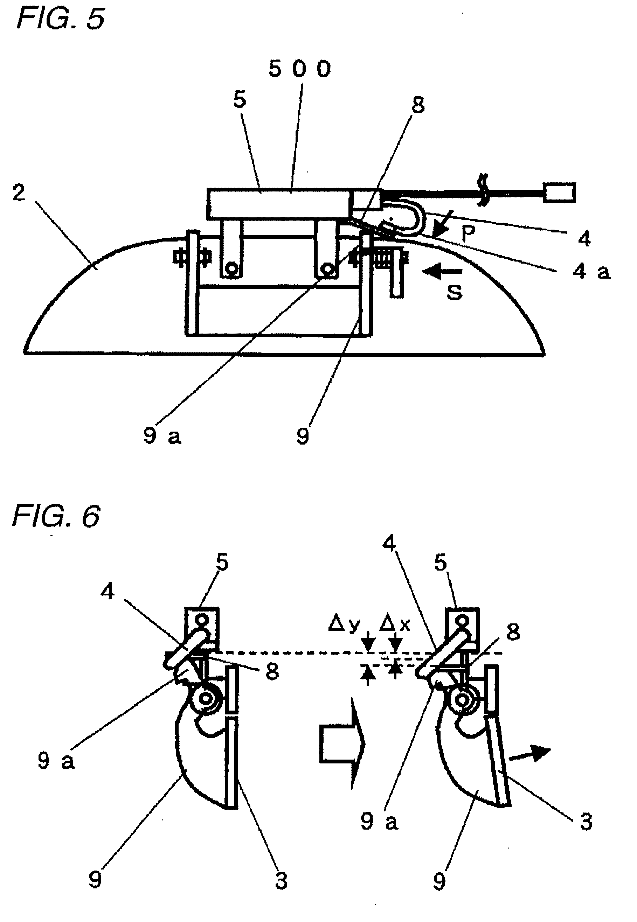

The operation is as follows: If a person pulls the doorknob 3 to the outside of the car or lightly touches the inside of the doorknob 3 to perform the door opening operation, the doorknob 3 is displaced to the outside of the car and the arm part 9 is displaced in conjunction with the doorknob 3. FIGS. 5 and 6 are schematic drawings to show displacement of the doorknob 3, the piezoelectric sensor 4, the elastic body 8, and the arm part 9 at the time. FIG. 6 is a schematic drawing of viewing FIG. 5 from S direction.
As shown in the figure, when the doorknob 3 is displaced to the outside of the car, the upper end 9a of the arm part 9 descends and the elastic body 8 urged against the upper end 9a under a predetermined pressure is also displaced downward to show the maximum displacement while the tip side rotates on a fix shaft 9b with a fix part as the center. Thus, the piezoelectric sensor 4 also becomes deformed in a direction in which the curvature radius of the bend part 4a increases.

At this time, for example, as shown in FIG 6, from the contact position relationship between the upper end 9a and the elastic body 8, although the upper end 9a is displacement of Δx, the tip part of the elastic body 8 becomes Δy larger than Δx and a larger displacement than the direct displacement of the upper end 9a is produced by the elastic body 8.

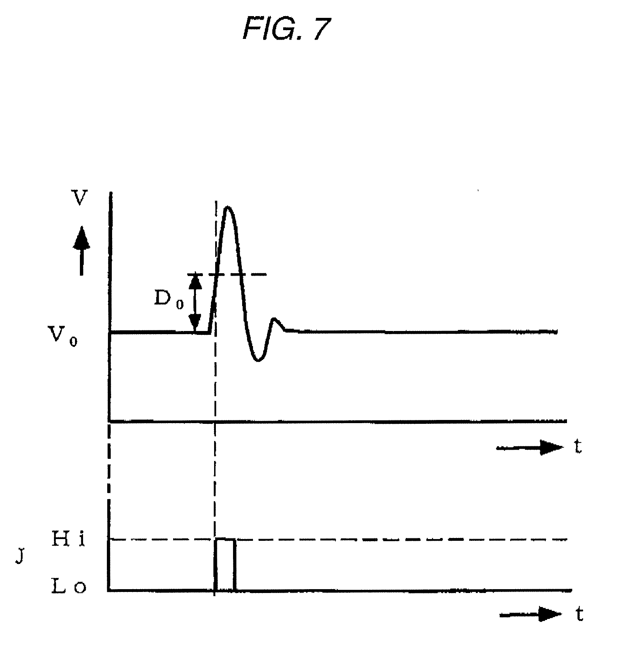

FIG. 7 is a characteristic drawing to show signal V amplified and filtered in the detection means 5 and determination output J of the determination section at the time. In the figure, the vertical axis shows V and J in order from the top and the horizontal axis shows time t. If a displacement occurs as the doorknob 3 is operated and the piezoelectric sensor 4 becomes deformed, the piezoelectric sensor 4 outputs a signal responsive to the acceleration of the deformation of the piezoelectric sensor 4 by the piezoelectric effect.
At this time, a signal having a frequency of about 3 to 8 Hz appears in the output signal and is amplified and filtered in the detection means 5 and a signal as indicated in V in FIG. 7 is obtained,

If absolute value |V-V0| of amplitude from V0 of V is D0 or more, the determination section determines that at least one of contact of an object with the doorknob 3, and the opening operation with the doorknob 3, and the closing operation with the doorknob 3 occurs, and outputs a low-to-high-to-low pulse signal as determination output at time t1.

If the doorknob 3 is pushed from the outside of the car, the piezoelectric sensor 4 also becomes deformed through the arm part 9 and the elastic body 8. In this case, the bend part 4a of the piezoelectric sensor 4 becomes deformed in a direction in which the curvature radius decreases and therefore the piezoelectric sensor 4 outputs an output signal of the opposite polarity to the case where the bend part 4a becomes deformed in the direction in which the curvature radius increases from the output characteristic of the piezoelectric sensor 4. Accordingly, a minus signal from the reference potential V0 in FIG. 7 appears in the filter signal V. If absolute value |V-V0| of amplitude from V0 of V is D0 or more, the determination section determines that at least one of contact of an object with the doorknob 3, and the opening operation with the doorknob 3, and the closing operation with the doorknob 3 occurs, and outputs a high signal for the time period over which |V-V0| is D0 or more. Thus, if the doorknob 3 is pushed from the outside of the car, it can also be detected and good convenience is provided. Particularly, when a person holds a load in both hands or if a weak child or old person uses, the ease of use improves because the operation of pushing the doorknob 3 from the outside of the car is easier than the operation of pulling the doorknob 3 to the outside of the car.

As the described operation is performed, in the door handle unit, it is made possible for the piezoelectric sensor to have flexibility and be added to the doorknob 3 and it is made possible to detect minute displacement of the doorknob 3 with high sensitivity. Therefore, sufficient signal output is obtained as a person simply touches the doorknob 3, and it is made possible to detect touch on the doorknob 3. Since the electrode need not be exposed, the effect of disturbance and deposited dust, rain, snow, etc., is hard to receive. Further, the piezoelectric sensor can become flexibly deformed and thus the number of restrictions on the installation place is small and the placement space also lessens.

The piezoelectric sensor 4 is supported on the elastic body 8 shaped roughly like a plate with one end fixed like a cantilever and when the doorknob 3 is unused, a part of the elastic body 8 is urged by a predetermined pressure and comes in contact with the upper end of the arm part 9; since the piezoelectric sensor 4 comes in contact with the upper end of the arm part 9 through the elastic body 8, for example, the piezoelectric sensor 4 does not come in contact with the arm part 9 and thus does not wear and does not receive directly operation shock and reliability improves.

When the doorknob 3 is unused, a part of the elastic body 8 is urged by the predetermined pressure and comes in contact with the upper end of the arm part 9. Thus, when the opening operation of the doorknob 3 is performed, at the upper end of the arm part 9, the elastic body 8 and the piezoelectric sensor 4 displace following displacement of the doorknob 3 and the detection means 5 outputs an open detection signal in response to the deformation of the piezoelectric sensor 4. After predetermined displacement, the elastic body 8 does not displace and the piezoelectric sensor 4 also remains deformed and thus a break in the piezoelectric sensor 4 because of too large displacement amount does not occur, so that the reliability of the sensor unit 500 improves.

The positional relationship among the arm part 9, the elastic body 8, and the piezoelectric sensor 4 is adjusted, whereby the detection area and the displacement amount can be adjusted and it is also made possible to optimize the sensor unit 500 for various door handle units different in structure, dimensions, etc.

From the contact position relationship between the upper end and the elastic body 8, displacement of the tip part of the elastic body 8 becomes larger than displacement of the upper end of the arm part 9 and displacement of the piezoelectric sensor 4 becomes larger and sensitivity improves.

The piezoelectric sensor 4 includes the bend part in the extension direction from the tip side of the elastic body 8 and when the same displacement is received, an output signal for deformation of the bend part can be taken larger than that of a linear part, so that the sensitivity of the piezoelectric sensor 4 improves. As the sensitivity of the piezoelectric sensor 4 improves, for .example, the amplification factor of signal processing can also be decreased in the detection means 5 installed in the sensor unit 500, so that the effect of electric noise can be decreased and the installation number of amplifiers of operational amplifiers, etc., can be reduced and miniaturization of the unit is also made possible.

The piezoelectric sensor 4, the elastic body 8, and the detection means 5 are molded in one piece to form the sensor unit 500 and can.be attached to the door 1 as the sensor unit 500, so that assembling as the door handle unit can be performed efficiently.

### (Second embodiment)

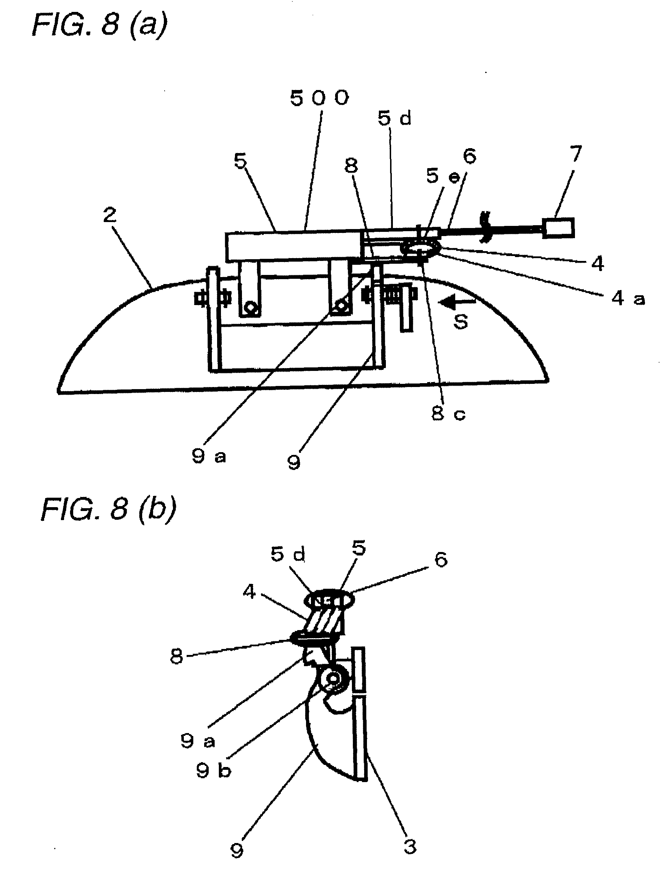

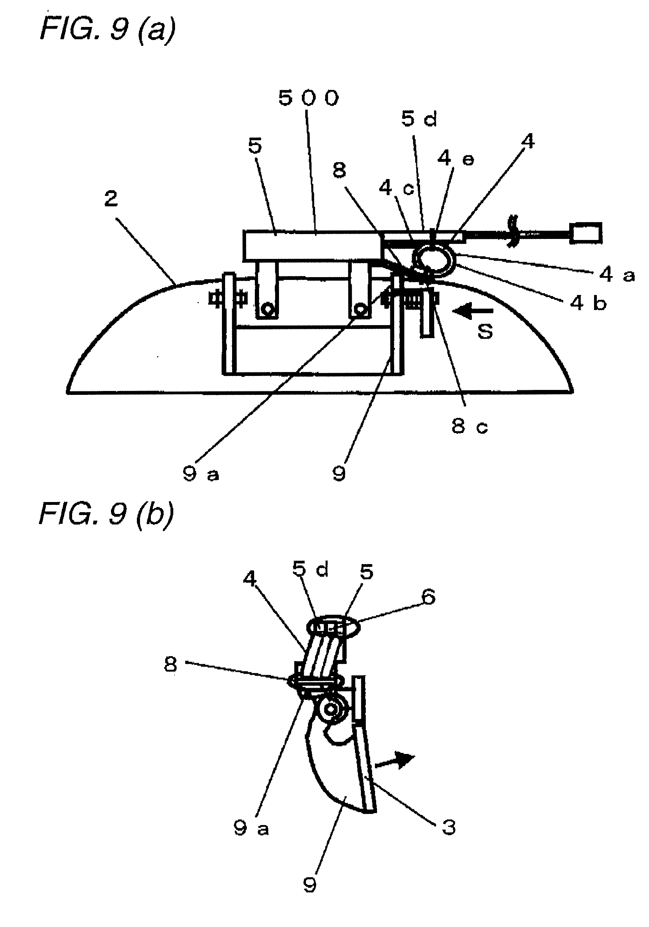

A second embodiment of the invention will be discussed with reference to FIGS. 8 and 9.

FIG. 8(a) is an external view of a handle bracket 2 when it is viewed from the car inside in the second embodiment of the invention, FIG. 8(b) is a schematic-drawing of viewing FIG. 8(a) from S direction, FIG. 9(a) is a schematic drawing to show displacement of a doorknob 3, a piezoelectric sensor 4, an elastic body 8, and an arm part 9 at the operation time of the doorknob 3 of the handle bracket 2 in the second embodiment of the invention, and FIG. 9(b) is a schematic drawing of viewing FIG. 9(a) from S direction.
The embodiment differs from the first embodiment in that a bend part 4a of the piezoelectric sensor 4 is formed by turning the piezoelectric sensor 4 at least one or more (turning it two and a half in FIGS. 8 and 9), as shown in FIGS. 8 and 9. After the piezoelectric sensor 4 is turned at the bend part 4a, it is bound and is supported on the elastic body 8 and a support part 8c and is also supported on a guide part 5d and a support part 5e extended from detection means 5. At the support parts 8c and 5e, using a binding band, etc., they are fixed with the elastic body 8 and the guide 5d as the stack state of the turned piezoelectric sensor 4 is held. The fixing is not limited to this method and they may be hooked on a fixture shaped like a hook, etc.; it is advisable to fix them in a loose fit state, but preferably the support parts and the piezoelectric sensor are not fixed with an adhesive, etc. If the shape of the piezoelectric sensor 4 is fixed with an adhesive, etc., it is not preferred because deformation of the piezoelectric body is blocked and deformation of the piezoelectric sensor is suppressed and output lessens.

The contact face of the support part 8c and the support part 5e with the piezoelectric sensor may be in.contact with a part of the bend part 4a; preferably it is a wider area than the bend part 4a of the piezoelectric sensor 4 stacked facing the support part 8c because the bend part 4a is deformed reliably at the same time.

If the number of turns is increased, the rigidity of the whole deformation portion including the bend part 4a increases and deformation becomes hard to occur and therefore to avoid this, a braided wire is used as an outer electrode 4d of the piezoelectric sensor 4. At the time, for example, if an extra fine wire of a tinned copper wire having a diameter of 50 µm or less is used as an element wire forming the braided wire and is interleaved to the surrounding of a piezoelectric body 4c at pitches of 4 to 10 mm, the flexibility of the piezoelectric sensor 4 increases and improves as compared with the structure of winding the belt-like electrode used in the first embodiment and thus if the piezoelectric sensor 4 is turned at the bend part 4a as described above, an increase in the rigidity of the bend part 4a can be suppressed and a structure of easy deformation can be realized.

If the braided wire as mentioned above is used, as the working speed of forming the outer electrode 4d, speed equal to or higher than that of winding the belt-like electrode can also be realized and productivity can be improved. Resistance to strong field noise equal to that of winding the belt-like electrode can be provided by the braided wire.

For the piezoelectric sensor 4, to wind a belt-like electrode as the outer electrode 4d, the belt-like electrode is wound as partial overlap and thus if the piezoelectric sensor 4 is bent and disposed, the belt-like electrode produces partial looseness in a coating layer 4 at the bend part. Therefore, if the bend part of the piezoelectric sensor 4 becomes deformed, the belt-like electrode is partially loose and thus the belt-like electrode and the piezoelectric body 4c may rub against each other, frictional electricity may be generated, and noise may occur, causing erroneous detection to occur. On the other hand, if a braided wire made of extra fine wires as described above is used for the outer electrode 4d, the close contact between the piezoelectric body 4c and the braided wire is good, so that the braided wire does not produce partial looseness at the bend part and if the bend part becomes deformed, generation of frictional electricity causing noise is suppressed and erroneous detection can be prevented.

According to the described configuration, if a person pulls the doorknob 3 to the outside of the car or lightly touches the inside of the doorknob 3 to perform the door opening operation as in FIG. 9 from the state in FIG 8, the doorknob 3 is displaced to the outside of the car and an upper end 9a of the arm part 9 descends in conjunction with the doorknob 3 and the elastic body 8 urged against the upper end 9a under a predetermined pressure is also displaced downward to show the maximum displacement while the tip side rotates on a fix shaft 9b with a fix part as the center. Thus, the piezoelectric sensor 4 also becomes deformed; particularly it becomes deformed in a direction in which the curvature radiuses of both side parts 4b and 4c of the bend part 4a shown in FIG. 9 (b) increase. A voltage signal is generated in response to the acceleration of the deformation of the piezoelectric sensor 4 by the piezoelectric effect.

According to the described operation, when the same displacement is received, the bend part formed by turning the piezoelectric sensor 4 at least one or more has a larger number of bend points than the bend part formed simply by making a U turn of the piezoelectric sensor 4 as in the first embodiment and the charge generation amount based on the piezoelectric effect increases according to the number of the bend points and an output signal can be taken larger, so that the sensitivity of the piezoelectric sensor 4 further improves and the detection time of doorknob operation and that of contact with the doorknob can be further shortened.

If the doorknob 3 is pushed from the outside of the car, the piezoelectric sensor 4 also becomes deformed through the arm part 9 and the elastic body 8. Particularly, the curvature radiuses of both side parts 4b and 4c become deformed in the lessening direction from the state in FIG. 8, so that a large voltage signal is output from the piezoelectric sensor 4 by the piezoelectric effect in a similar manner to that described above and if the doorknob 3 is pushed from the outside of the car, the sensitivity of the piezoelectric sensor 4 further improves and the detection time of doorknob operation and that of contact with the doorknob can be further shortened.

In the embodiment, to turn the piezoelectric sensor 4 at the bend part 4a, the sequential stack structure is adopted so as to make the winding shape of the piezoelectric sensor 4 the same shape as shown in FIGS. 8 and 9. However, for example, the piezoelectric sensor 4 may be turned spirally like a mosquito-repellent incense to form the bend part 4a or the piezoelectric sensor 4 may be turned like a spherical surface from various directions as when a traditional Japanese handball is made to form the bend part 4a; any of other various turn structures may be used if the number of bend points increases when the bend part 4a of the piezoelectric sensor 4 receives deformation.

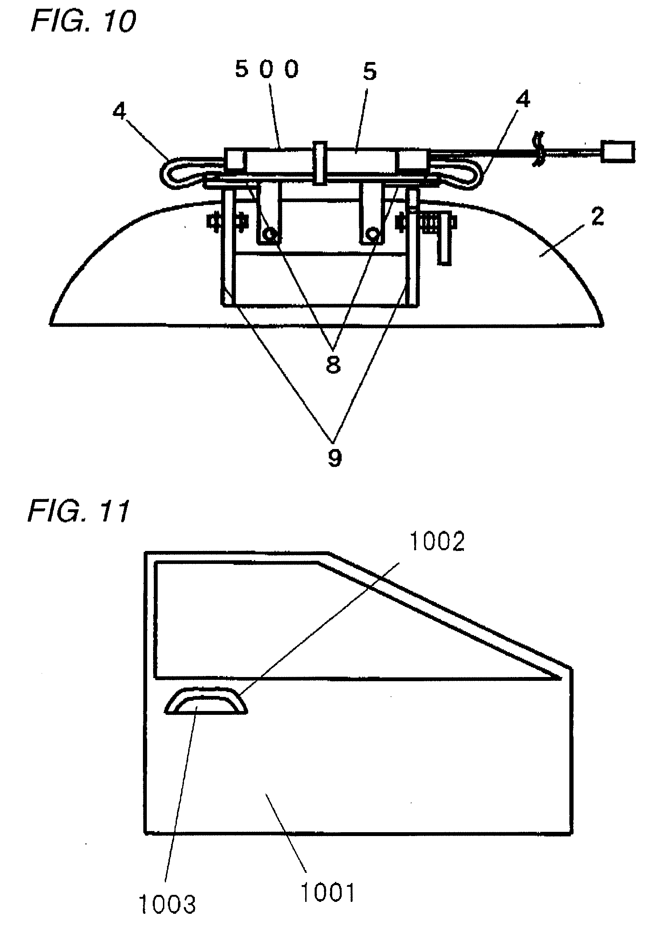

As another embodiment of the invention, elastic bodies 8 may be provided in a one-to-one correspondence with two arm parts 9 operating in conjunction with a doorknob 3 and piezoelectric sensors 4 are supported on and fixed to the two elastic bodies 8 as shown in FIG. 10. Since displacement of the doorknob is detected at more than one place, redundancy of detection is enhanced and reliability of detection is improved.

An automobile with the door handle unit of the above-described embodiment applied to a smart entry system in doors of a side door, a tail gate, etc., and a building with the door handle unit applied to a smart entry system in doors of a front door, etc., can be provided.

Any other machine may be controlled in various manners based on an output signal of the door handle unit of the above-described embodiment. For example, the door handle unit of the above-described embodiment may be disposed in a power slide door or a power hatch back door of an automobile or a door such as an automatic door of a building and doorknob operation may be detected for controlling automatic opening and closing of the door; convenience improves. At this time, using the fact that the polarity of the output signal of the piezoelectric sensor 4 becomes opposite when the doorknob 3 is pulled from the outside of the car and when the doorknob 3 is pushed as mentioned in the description of the operation of the embodiment, door opening/closing control may be performed based on the polarity of the output signal of the piezoelectric sensor 4, for example, in such a manner that when the doorknob 3 is pulled from the outside of the car, the door is opened and that the doorknob 3 is pushed from the outside of the car, the door is closed.

The door opening/closing speed may be controlled in response to the magnitude of the output signal of the piezoelectric sensor 4. For example, according to a configuration wherein the larger the output signal of the piezoelectric sensor 4, the higher the door opening/closing speed, if the user wants to open or close a door quickly, he or she may operate the doorknob 3 strongly for increasing the output signal from the piezoelectric sensor 4; convenience improves.

In addition, the door handle unit can be applied to control of various machines in such a manner that a power window is opened and closed, that illumination is turned on and off and is dimmed, or that an AV machine is turned on and off based on an output signal of the door handle unit.

### (Third embodiment)

A third embodiment of the invention will be discussed with reference to FIGS. 11 to 19.

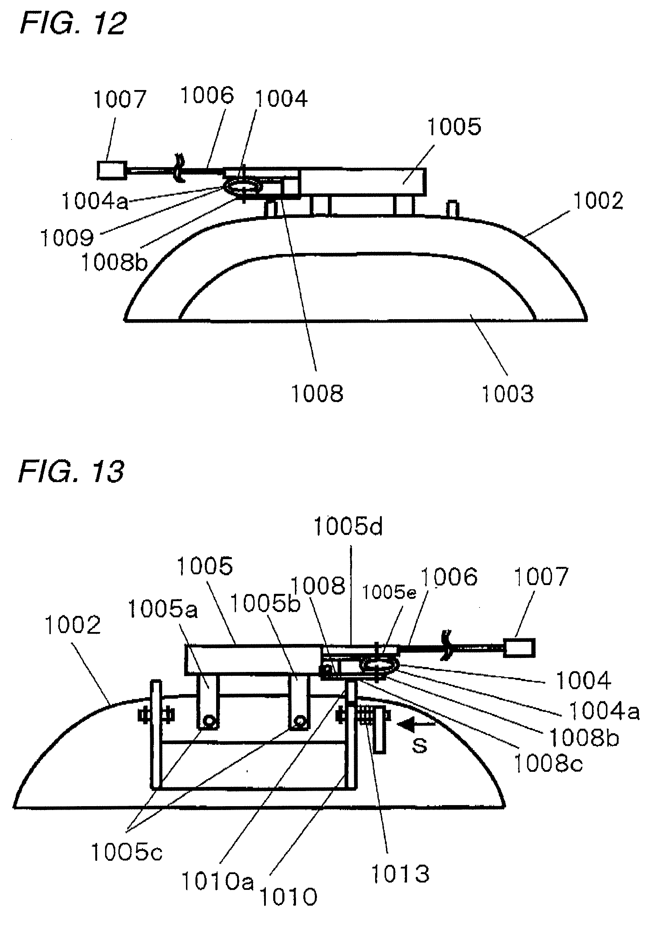

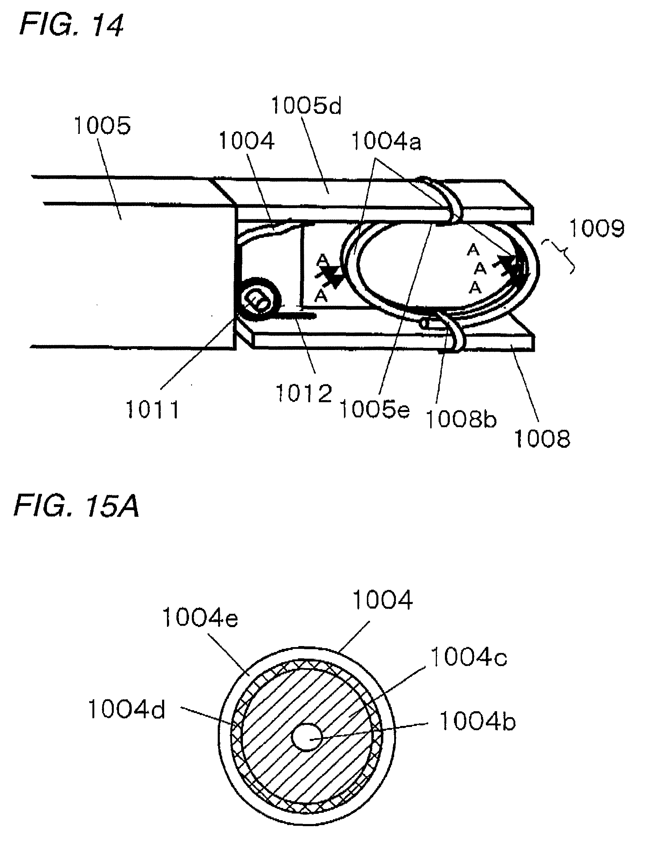

FIG 11 is an external view of an automobile door including a door handle unit including a contact detector in the third embodiment of the invention. In the figure, a handle bracket 1002 is attached to a door 1001. The handle bracket 1002 has a door handle 1003. FIG 12 is an external view of the handle bracket 1002 when it is viewed from the car outside, FIG. 13 is an external view of the handle bracket 1002 when it is viewed from the car inside, and FIG. 14 is an enlarged perspective view to show the main part of the handle bracket 1002. In the figure, a piezoelectric sensor 1004 having flexibility is attached to the handle bracket 1002 together with detection means 1005. A cable 1006 and a connector 1007 for power supply and detection signal output are connected to the detection means 1005, which incorporates signal processing means. Support means 1008 shaped like a plate is supported for rotation in an upper end part of a side of the detection means 1005 and is extended, and the piezoelectric sensor 1004 is supported on and fixed to the tip of the support means 1008 (support part 1008b in the figure). The piezoelectric sensor 4 includes a multilayer superposition part 1009 as a simultaneous deformation part made up of a plurality of bend parts 1004a formed by turning the piezoelectric sensor 1004 at least one or more (turning it two and a half in FIGS. 12, 13, and 14). After the piezoelectric sensor 1004 is turned at the bend parts 1004a, it is bundled.and supported on the support means 1008 and the support part 1008b and from the top of the detection means 1005, a guide part 1005d is extended and the guide part 1005d and a support part 1005e of position regulation means support the piezoelectric sensor 1004. At the support parts 1008b and 1005e, using a binding band, etc., they are fixed with the support means 1008 and the guide 1005d as the stack state of the turned piezoelectric sensor 1004 is held. The fixing is not limited to this method and they may be hooked on a fixture shaped like a hook, etc.; it is advisable to fix them in a loose fit state in which only a part of the turn portion of the piezoelectric sensor (multilayer superposition part) is fixed and others have a play portion, but preferably the support parts and the piezoelectric sensor are not fixed with an adhesive, etc. If the shape of the piezoelectric sensor 1004 is fixed with an adhesive, etc., it is not preferred because deformation of the piezoelectric body is blocked and deformation of the piezoelectric sensor is suppressed and output lessens.

The contact face of the support part 1008b and the support part 1005e with the piezoelectric sensor may be in contact with a part of the multilayer superposition part; preferably it is a wider area than the bend part 1004a of the piezoelectric sensor 1004 stacked facing the support part 1008c because the multilayer superposition part is deformed reliably at the same time. That is, the embodiment is not limited to the configuration because the piezoelectric sensor may be in contact with the support part 1008b and the support part 1005e so that the plurality of bend parts of the piezoelectric sensor produce deformation at the same time.

A moving part 1008c of the support means 1008 is in contact with an arm part 1010 operatively connected to the door handle 1003 at an upper end 1010a as shown in FIGS. 13 and 14. The portions indicated by five arrows A in FIG 14 are the simultaneous deformation part of the bend parts formed by winding the piezoelectric sensor 1004. The support means 1008 is supported for rotation with a shaft 1011 fixed to the detection means 1005 and the guide part 1005d as a rotation shaft and when the door handle 1003 is unused, the support means 1008 is urged under a predetermined pressure and is in contact with the upper end 1010a of the arm part by the action of a spring 1012 of elastic body joint means.
A predetermined spring pressure is applied to the arm part 1010 by a handle spring 1013, so that the door handle 1003 is pressed in the closed direction at all times. The detection means 1005 is attached to the handle bracket 1002 with screws 1005c through mounting brackets 1005a and 1005b.

FIG 15A is a sectional view of the piezoelectric sensor 1004. The piezoelectric sensor 1004 is provided by shaping a center electrode 1004b, a piezoelectric body 1004c, an outer electrode 1004d, and a coating layer 1004e coaxially; it has a structure excellent in flexibility as a whole. The center electrode 1004b may use a usual metal solid conductor wire; here, an electrode having a metal coil wound on the circumference of insulating polymer fiber is used. Preferably, polyester fiber commercially used in an electric blanket and a copper alloy containing 5 wt% of silver are used as the insulating polymer fiber and the metal coil respectively..

The piezoelectric body 1004c is provided by mixing and kneading polyethylene base resin and piezoelectric ceramic (here, lead titanate zirconate) powder; they are squeezed out continuously together with the center electrode 1004b to form the piezoelectric body 1004c having flexibility. As the piezoelectric ceramic, preferably, non-lead base material, for example, piezoelectric ceramic material based on bismuth sodium titanate or niobate alkali is used from consideration for the environment.

After the piezoelectric body 1004c is squeezed out on the circumference of the center electrode 1004b, several k V DC voltage is applied between the center electrode 1004b and a pseudo electrode brought into contact with the surface of the piezoelectric body 1004c to perform polarization of the piezoelectric body 1004c. Accordingly, the piezoelectric body 1004c is provided with the piezoelectric effect.

The outer electrode 1004d is formed using a metal wire of a braid structure. To form the multilayer superposition part 1009, if the number of turns of the piezoelectric sensor 1004 is increased, the rigidity of the whole deformation portion including the bend parts 1004a increases and deformation becomes hard to occur and therefore to avoid this, a braided wire is used as the outer electrode 1004d of the piezoelectric sensor 1004. At the time, for example, if an extra fine wire of a tinned copper wire having a diameter of 50 µm or less is used as an element wire forming the braided wire and is interleaved to the surrounding of a piezoelectric body 1004c at pitches of 4 to 10 mm, the flexibility of the piezoelectric sensor 1004 increases and improves as compared with the structure of winding a belt-like electrode as a metal film is adhered onto a polymer layer and thus if the piezoelectric sensor 1004 is turned at the bend part 1004a as described above, an increase in the rigidity of the bend part 1004a can be suppressed and a structure of easy deformation can be realized.

If the braided wire as mentioned above is used, as the working speed of forming the outer electrode 1004d, speed equal to or higher than that of winding the belt-like electrode can also be realized and productivity can be improved. Resistance to strong field noise equal to that of winding the belt-like electrode can be provided by the braided wire.

For the piezoelectric sensor 1004, to wind a belt-like electrode as the outer electrode 1004d, the belt-like electrode is wound as partial overlap and thus if the piezoelectric sensor 1004 is bent and disposed, the belt-like electrode produces partial looseness in a coating layer 1004 at the bend part. Therefore, if the bend part of the piezoelectric sensor 1004 becomes deformed, the belt-like electrode is partially loose and thus the belt-like electrode and the piezoelectric body 1004c may rub against each other, frictional electricity may be generated, and noise may occur, causing erroneous detection to occur. On the other hand, if a braided wire made of extra fine wires as described above is used for the outer electrode 1004d, the close contact between the piezoelectric body 1004c and the braided wire is good, so that the braided wire does not produce partial looseness at the bend part and if the bend part becomes deformed, generation of frictional electricity causing noise is suppressed and erroneous detection can be prevented.

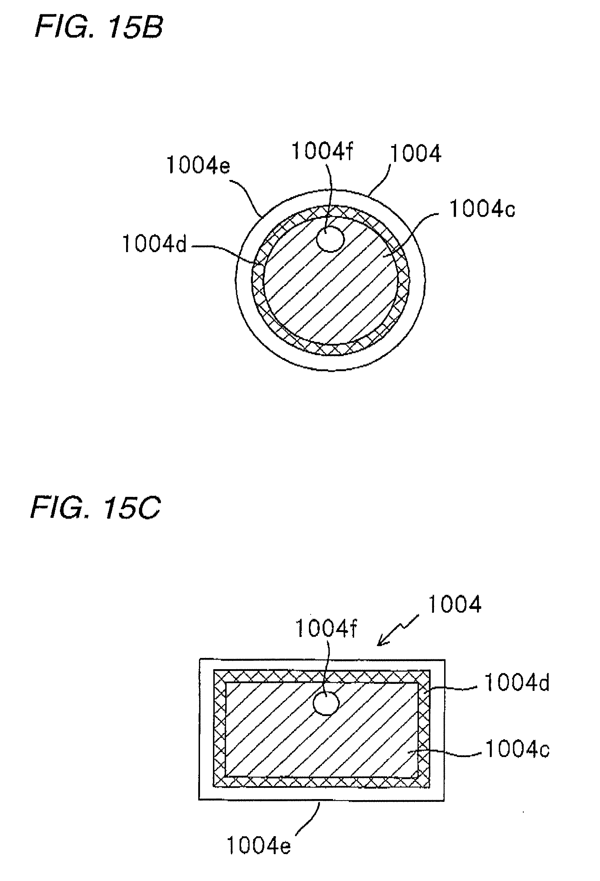

FIG 15B shows a modified example of the piezoelectric sensor 1004. The piezoelectric sensor 1004 shown in FIG. 15B has an eccentric structure wherein a center electrode 1004f is formed at an eccentric position relative to the piezoelectric body 1004c. Others are as described with FIG. 15A. According to the configuration, when the piezoelectric sensor 1004 is deformed so as to have a bend part for use, for example, when the piezoelectric sensor is bent for use so that the center electrode 1004f becomes the outside, large output is provided because a large tension is put on the center electrode 1004f as compared with the piezoelectric sensor of the configuration shown in FIG. 15A. In contrast, when the piezoelectric sensor is bent for use so that the center electrode 1004f becomes the inside, small output is provided on the center electrode 1004f as compared with the piezoelectric sensor of the configuration shown in FIG. 15A.

FIG 15C shows a modified example of the piezoelectric sensor 1004. The piezoelectric sensor 1004 shown in FIG. 15C has an eccentric structure wherein a center electrode 1004f is formed at an eccentric position relative to the piezoelectric body 1004c and is formed like a rectangle. Others are as described with FIG. 15A. According to the configuration, when the piezoelectric sensor is wound more than once to form a bend part, flat parts of a peripheral surface are superposed on each other in cross-sectional rectangle for formation, so that the arrangement becomes good and the eccentric direction becomes easy to determine and it becomes easy to position at the predetermined side of bend (outside or inside).

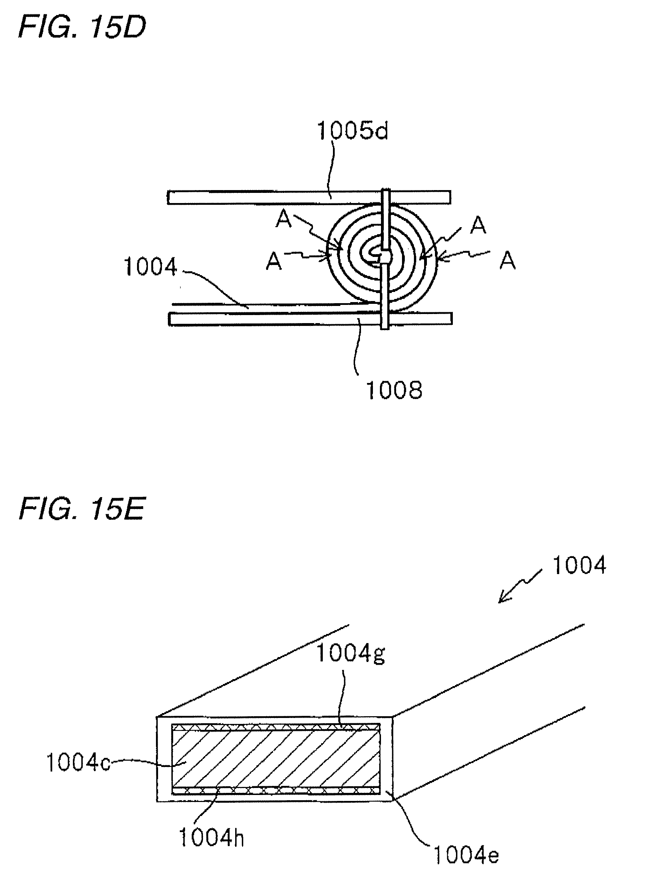

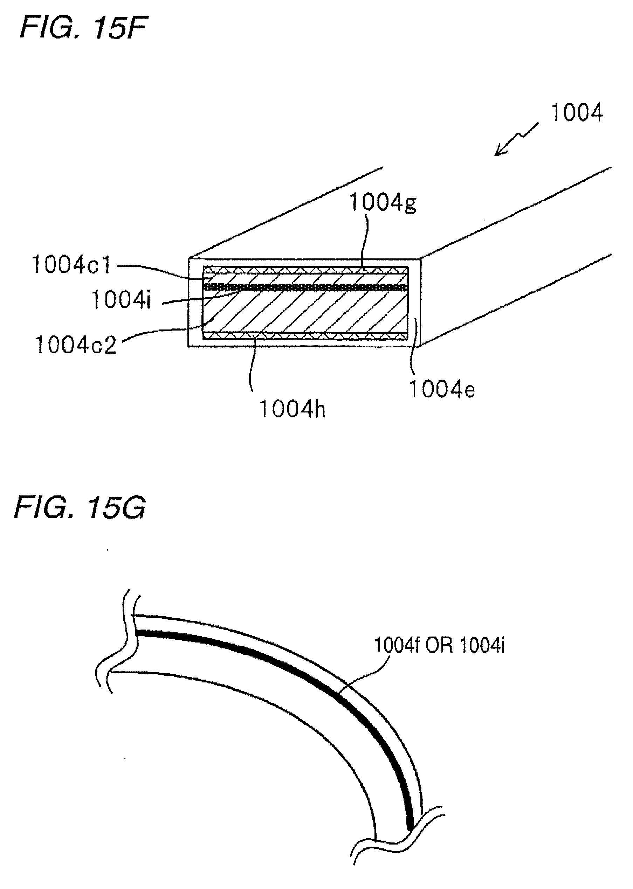

In the description given so far, it is assumed that the piezoelectric sensor formed of a coaxial cable having flexibility is used. However, as the piezoelectric sensor, a turn structure or a superposition structure shaped like a long shape needs only to be formed; a piezoelectric sensor formed like tape may be used. For example, as shown in FIG. 15D, a tape-like piezoelectric sensor 1004 may be used and wound in the same plane to form simultaneous bend parts A. As shown in FIG. 15E, a piezoelectric body 1004c having flexibility is sandwiched between a first electrode 1004g and a second electrode 1004h as a stack and the whole is covered with a coating layer 1004e to form a piezoelectric sensor 1004 shaped like a fine string or a thin ribbon (tape) having a predetermined length, whereby a structure including a plurality of simultaneous bend parts can be implemented. The simultaneous bend parts of the long piezoelectric element having flexibility become deformed, so that displacement is detected, a sufficient voltage is generated, and improvement of sensitivity as well as attachment ease as a sensor can be accomplished.
As a modified example of the tape-like piezoelectric sensor 1004, a first electrode 1004g, a first piezoelectric body 1004c1, a core electrode 1004i, a second piezoelectric body 1004c2, and a second electrode 1004h may be stacked and may be covered with a coating layer 4e, as shown in FIG. 15F. In the figure, the core electrode 1004i is formed at an eccentric position from the center to the first electrode 1004g side and the first piezoelectric body 1004c1 is formed thinner than the second piezoelectric body 1004c2.
If the piezoelectric sensor 1004 of the eccentric structure as shown in FIG. 15B, 15C, or 15F is polarized at a predetermined voltage, the electric field strength becomes large in the thin portion of the piezoelectric body 1004c and thus sensitivity (output relative to deformation) is easy to become large. As shown in FIG. 15G, the part where the sensitivity is large is positioned on the outside where the deformation amount is large, whereby large output is provided. If the sensitivity is small because of the thickness of the piezoelectric body 1004c, when the thin portion of the piezoelectric body 1004c with small rigidity relative to the center electrode 1004f or the core electrode 1004i comes to the outside, the thin portion becomes deformed concentrically and large output is provided.
In contrast, the electric field strength lessens in the thick portion of the piezoelectric body 1004c and thus sensitivity (output relative to deformation) is easy to become small. The output relative to deformation lessens.

The detection means 1005 includes at least one band pass filter section made up of an operational amplifier and a peripheral component and a band elimination filter section or a low-pass filter section made up of an operational amplifier and a peripheral component for eliminating a signal component containing a natural frequency of the door 1001. It includes a determination section for detecting at least one of contact of an object with the door handle 1003 and the opening operation and the closing operation with the door handle 1003 based on an output signal of the filter section. A comparator is used as the determination section. Each of the filter section and the determination section uses an element of low current consumption type of 1 mA or less.

The band pass filter section is set so as to become a characteristic such that it allows a frequency domain of 3 Hz to 8 Hz, for example, to pass through as a feature frequency band by conducting frequency analysis of an output signal from the piezoelectric sensor 1004 when the door handle 1003 is operated experimentally.

The band elimination filter section or the low-pass filter section is set so as to become a characteristic such that it eliminates a frequency domain of 10 Hz or more, for example, as a feature frequency band by conducting frequency analysis of an output signal from the piezoelectric sensor 1004 when the door 1001 is struck by intention, for example. If the strength of the natural frequency is small and the effect on the output signal of the piezoelectric sensor 1004 is small, the band elimination filter section or the low-pass filter section need not be provided.

Further, since it is assumed that the natural frequency characteristic of a door varies depending on the car type, the size, the weight of the door, etc., preferably the settings of the band pass filter section and the band elimination filter section or the low-pass filter section are optimized based on experimental analysis as.mentioned above.

To remove external electric noise, preferably the whole of the detection means 1005 is covered with a shield member to electrically shield the detection means 1005. A feedthrough capacitor, an EMI filter, etc., may be added to an input/output section of the detection means 1005 to take measures against a strong field.

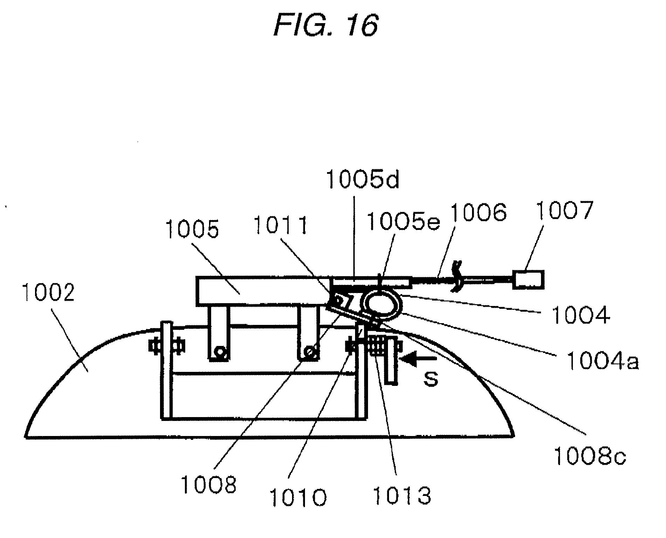

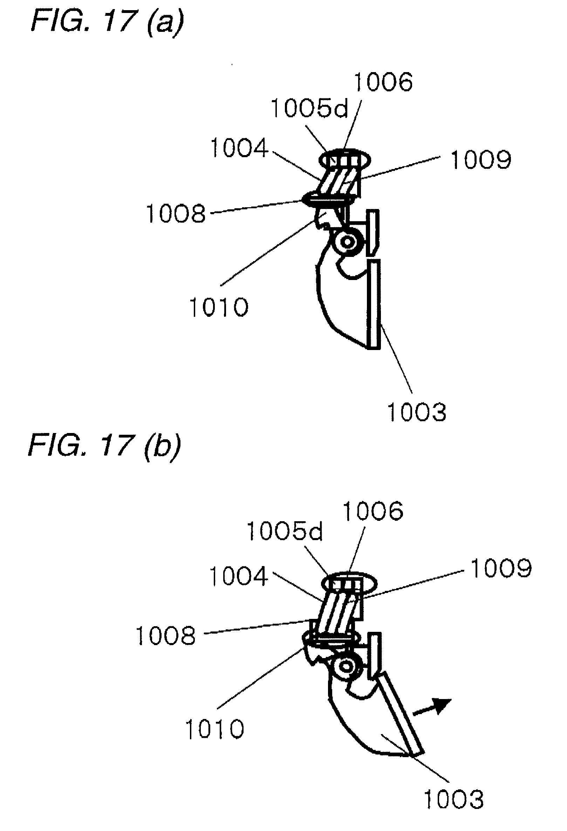

The operation is as follows: If a person pulls the door handle 1003 to the outside of the car or lightly touches the inside of the door handle 1003 to perform the door opening operation, the door handle 1003 is displaced to the outside of the car and the arm part 1010 is displaced in conjunction with the door handle 1003. FIGS. 16 and 17 are schematic drawings to.show displacement of the door handle 1003, the piezoelectric sensor 1004, the support means 1008, and the arm part 1010 at the time. FIG. 17 is a schematic drawing of viewing FIGS. 13 and 16 from S direction. As shown in the figure, when the door handle 1003 is displaced to the outside of the car, the upper end 1010a of the arm part 1010 descends and the support means 1008 urged against the upper end 1010a under a predetermined pressure is also displaced downward to show the maximum displacement while the tip side rotates with the shaft 1011 as the center. Thus, the piezoelectric sensor 1004 also becomes deformed in a direction in which the curvature radius of the bend part 1004a increases.

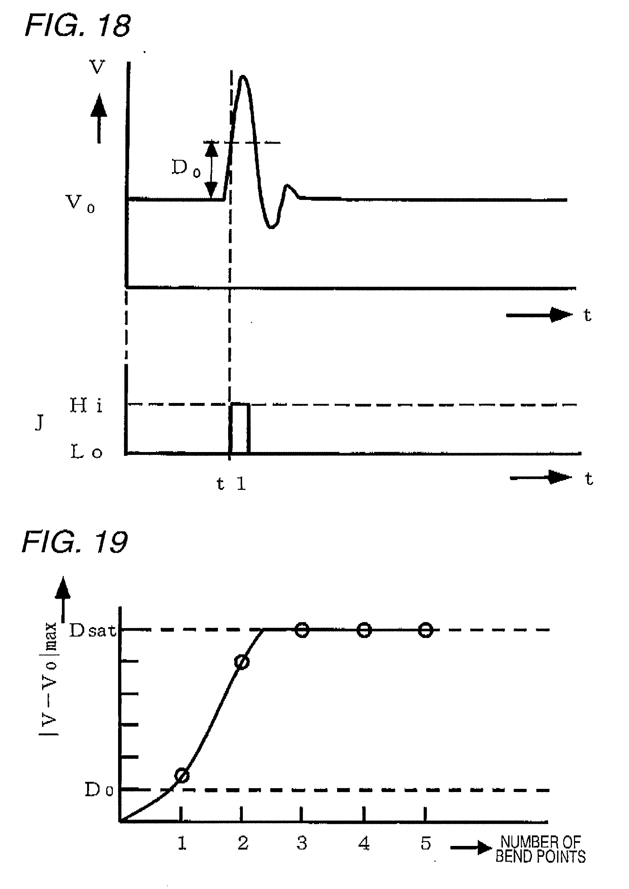

FIG. 18 is a characteristic drawing to show signal V amplified and filtered in the detection means 1005 and determination output J of the determination section at the time. In the figure, the vertical axis shows V and J in order from the top and the horizontal axis shows time t. If a displacement occurs as the door handle 1003 is operated and the piezoelectric sensor 1004 becomes deformed, the piezoelectric sensor 1004 outputs a signal responsive to the acceleration of the deformation of the piezoelectric sensor 1004 by the piezoelectric effect. At this time, a signal having a frequency of about 3 to 8 Hz appears in the output signal and is amplified and filtered in the detection means 1005 and a signal as indicated in V in FIG. 18 is obtained.

If absolute value |V-V0| of amplitude from V0 of V is D0 or more, the determination section determines that at least one of contact of an object with the door handle 1003, and the opening operation with the door handle 1003, and the closing operation with the door handle 1003 occurs, and outputs a low-to-high-to-low pulse signal as determination output at time t1.

If the door handle 1003 is pushed from the outside of the car, the piezoelectric sensor 1004 also becomes deformed through the arm part 1010 and the support means 1008. In this case, the bend part 1004a of the piezoelectric sensor 1004 becomes deformed in a direction in which the curvature radius decreases and therefore the piezoelectric sensor 1004 outputs an output signal of the opposite polarity to the case where the bend part 1004a becomes deformed in the direction in which the curvature radius increases from the output characteristic of the piezoelectric sensor 1004, Accordingly, a minus signal from the reference potential V0 in FIG. 18 appears in the filter signal V. If absolute value |V-V0| of amplitude from V0 of V is D0 or more, the determination section determines that at least one of contact of an object with the door handle 1003, and the opening operation with the door handle 1003, and the closing operation with the door handle 1003 occurs, and outputs a high signal for the time period over which |V-V0| is D0 or more. Thus, if the door handle 1003 is pushed from the outside of the car, it can also be detected and good convenience is provided. Particularly, when a person holds a load in both hands or if a weak child or old person uses, the ease of use improves because the operation of pushing the door handle 1003 from the outside of the car is easier than the operation of pulling the door handle 1003 to the outside of the car.

As the described operation is performed, in the door handle unit, it is made possible for the cable-like piezoelectric sensor 1004 to have flexibility and be attached to the contact detection target of the door handle 1003, etc. As displacement of the moving part 1008c is detected, when minute displacement at the contact time of a person or an object is detected, it is detected according to simultaneous deformation of a plurality of parts of the piezoelectric sensor. Thus, when the same displacement is received, if the number of bend points is large, the charge generation amount based on the piezoelectric effect increases according to the number of the bend points and an output signal can be taken larger, so that the sensitivity of the piezoelectric sensor 1004 improves and detection with higher sensitivity and higher output is made possible.

FIG. 19 shows the relationship between the number of bend parts and output signal in graph form. Of the output signal as shown in V in FIG. 18, the value at which absolute value |V-V0| of amplitude from V0 of V becomes the maximum is set to |V-V0|max and if the number of bend points is changed by changing the number of turns by experiment and output |V-V0|max is found, it is obvious that if the number of bend points increases, the output value becomes large and if the number of bend points exceeds three, the output value is saturated in the detection means 1005 for performing predetermined amplification and filtering. This saturation phenomenon is caused by the circuit characteristic and if limitation of the circuit characteristic is eliminated, signal output becomes large with the deformation amount.

Therefore, sufficient signal output is obtained as a person simply touches the contact detection target, and it is made possible to detect touch on the contact detection target. When the sensitivity of the piezoelectric sensor 1004 improves, for example, the amplification factor of signal processing can also be decreased in signal processing means installed in the detection means 1005, so that the effect of electric noise can be.decreased and the installation number of amplifiers of operational amplifiers, etc., can be reduced and miniaturization of the unit is also made possible. Since the electrode need not be exposed, the effect of disturbance and deposited dust, rain, snow, etc., is hard to receive. Further, the cable-like piezoelectric sensor can become flexibly deformed and thus the number of restrictions on the installation place is small and the placement space also lessens.

As the position regulation means of the piezoelectric sensor 1004, the guide part 1005d and the support part 1005e are fixed to the detection means 1005 and the support means 1008 is provided with the spring 1012 of joint means and is rotated, whereby the moving part 1008c and the position regulation means are joined with elasticity and the bend parts of the multilayer superposition part 1009 produce deformation at the same time with displacement of the moving part. Thus, pressure can be given for urging with the elasticity of the spring 1012 so that the moving part 1008c is easy to displace if a person comes in contact with the contact target, so that it is made possible to perform stable operation independently of the elasticity of the piezoelectric sensor 1004 and contact detection of a person or an object based on detection of minute displacement can be made with good responsibility and with higher sensitivity and higher output and the reliability can be improved.

The multilayer superposition part 1009 made up of a plurality of bend parts 1004a formed by turning the piezoelectric sensor 1004 at least one or more forms the simultaneous deformation part, whereby the configuration becomes compact and the number of restrictions on the installation place is small and the placement space also lessens.

The outer electrode 1004d of the cable-like piezoelectric sensor 1004 is formed of a braided metal wire, whereby the flexibility of the cable-like piezoelectric sensor 1004 improves, so that it becomes easy to perform bending to form the simultaneous deformation part, degradation of flexibility and an output anomaly occurring from deformation of the outer electrode 1004d caused by bending are prevented, detection with high sensitivity and high output is realized stably, and the reliability can be improved.

When the door handle 1003 is unused, a part of the support means 1008 is urged by the predetermined pressure and comes in contact with the upper end of the arm part 1010. Thus, when the opening operation of the door handle 1003 is performed, at the upper end of the arm part 1010, the support means 1008 and the piezoelectric sensor 1004 displace following displacement of the door handle 1003 and the detection means 1005 outputs an open detection signal in response to the deformation of the piezoelectric sensor 1004. After predetermined displacement, the support means 1008 does not displace and the piezoelectric sensor 1004 also remains deformed and thus a break in the piezoelectric sensor 1004 because of too large displacement amount does not occur, so that at repeatedly occurring deformation, restoration of the state before and after the deformation exists, and reproducibility of output also exists and thus the reliability of the detection means 1005 improves. About a configuration wherein the support means 1008 does not displace more than a predetermined amount following displacement of the arm part 1010, the elasticity of the elastic joint means 1012 and the contact position relationship with the arm part are adjusted, whereby the maximum displacement amount can be determined. Accordingly, a configuration considering the durability of the piezoelectric sensor 1004 is made possible and a configuration wherein bend degradation of the piezoelectric sensor is hard to occur if repeated deformation is received can be realized.

The positional relationship among the arm part 1010, the support means 1008, and the piezoelectric sensor 1004 is adjusted, whereby the detection area and the displacement amount can be adjusted and it is also made possible to optimize the detection means 1005 for various door handle units different in structure, dimensions, etc.

The piezoelectric sensor 1004, the support means 1008, and the detection means 1005 are molded in one piece to form the detection means 1005 and can be attached to the door 1001 as the detection means 1005, so that assembling as the door handle unit can be performed efficiently.

### (Fourth embodiment)

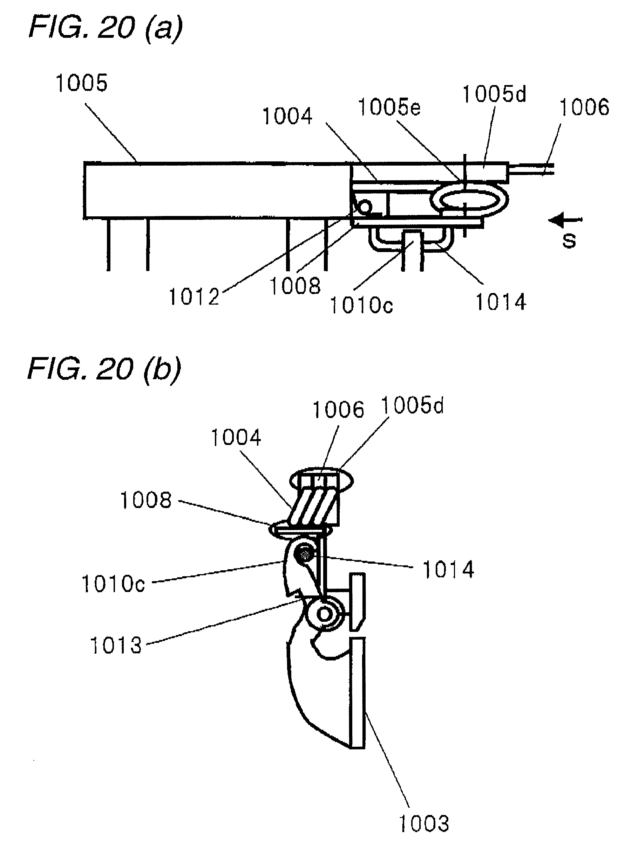

A fourth embodiment of the invention will be discussed with reference to FIG 20.

FIG 20 (a) is an enlarged external view of a handle bracket 1002 when it is viewed from the car inside in the fourth embodiment of the invention and FIG. 20 (b) is a schematic drawing of viewing FIG. 20 (a) from S direction. The embodiment differs from the third embodiment in that an upper end 1010c of an arm part 1010 is formed like a detachable latch shape and a rod-like hook part 1014 is provided in a lower part of support means 1008 so that the upper end 1010c and the hook part 1014 form a latch-type connection part, as shown in FIG. 20.

According to the described configuration, in the early stage of displacement of the arm part 1010 in operation of a door handle 1003, the upper end 1010c engages the hook part 1014 and displacement of the arm part 1010 is reliably transmitted to the support means 1008. As the door handle 1003 displaces to the outside of the car, the arm part 1010 moves down while rotating, so that the upper end 1010c shaped like a latch is detached from the hook part 1014 and the support means 1008 is restored to the former position before operation because of elasticity of a spring 10.12. Then, if the user moves his or her hand off the door handle 1003, the door handle 1003 is restored to the position at the unused time by the action of a handle spring 1013 and again the upper end 1010c engages the hook part 1014.

Thus, at least in the early stage of displacement of the moving arm in door handle operation, the engagement of the arm part 1010 and the support means 1008 and a moving part 1008c is maintained by the connection part, so that the moving part 1008c is not detached at the displacement time of the moving arm, the displacement is reliably transmitted, detection with high sensitivity and high output is realized stably, and the reliability can be improved. After predetermined displacement, the support means 1008 does not displace and a piezoelectric sensor 1004 also remains deformed and thus a break in the piezoelectric sensor 1004 because of too large displacement amount does not occur, so that the reliability of detection means 1005 improves.

If rainwater, etc., enters the handle bracket and it is exposed to a low temperature, the embodiment would make it possible to forcibly deform the piezoelectric sensor 1004 in conjunction with the arm part 1010, so that signal output can be reliably obtained if hardening or freezing of the sensor occurs.

### (Fifth embodiment)

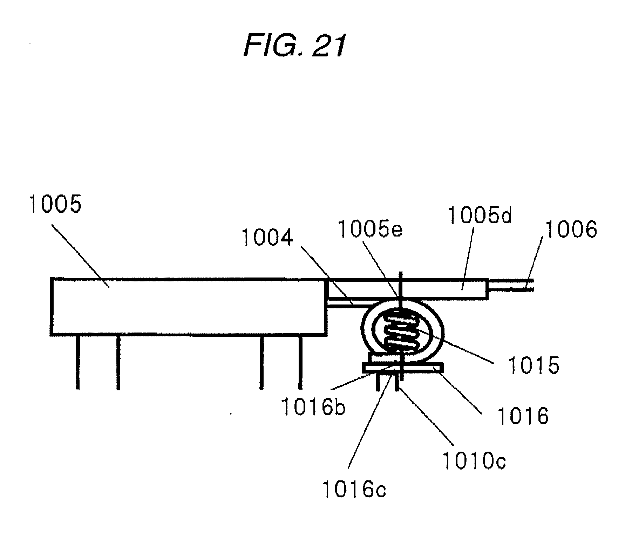

A fifth embodiment of the invention will be discussed with reference to FIG 21.

FIG 21 is an enlarged external view of the main part of a handle bracket 1002 when it is viewed from the car inside in the fifth embodiment of the invention. The embodiment differs from the third and fifth embodiments in that a controlling spring 1015 is provided in a loop of a piezoelectric sensor 1004 turned to form a multilayer superposition part 1009 and support means 1016, a support part 1016b, and a moving part 1016c are placed at a position opposed to a guide part 1005d of position regulation means, so that the support means 1016 is pressed against an upper end 1010c of an arm part 1010 by elasticity of the controlling spring, as shown in FIG. 20.

According to the configuration, as position regulation means of the piezoelectric sensor 1004, the guide part 1005d and a support part 1005e are fixed to detection means 1005 and the support means 1016 is provided with a controlling spring 1015 of joint means and is moved up and down, whereby the moving part 1016c and the position regulation means are joined with elasticity and the multilayer superposition part 1009 is deformed with displacement of the moving part. Thus, when a door handle 1003 is unused, the moving part 1016c of the support means 1016 is urged under a predetermined pressure and is in contact with the upper end of the arm part 1010, so that when the opening operation of the door handle 1003 is performed, at the upper end of the arm part 1010, the support means 1016 and the piezoelectric sensor 1004 displace following displacement of the door handle 1003 and the detection means 1005 outputs an open detection signal in response to the deformation of the piezoelectric sensor 1004, Accordingly, pressure can be given for urging with the elasticity of the controlling spring 1015 so that the moving part 1016c is easy to displace if a person comes in contact with the contact target, so that it is made possible to perform stable operation independently of the elasticity of the piezoelectric sensor 1004 and contact detection of a person or an object based on detection of minute displacement can be made with good responsibility and with higher sensitivity and higher output and the reliability can be improved. After predetermined displacement, the support means 1016 does not displace and the piezoelectric sensor 1004 also remains deformed and thus a break in the piezoelectric sensor 1004 because of too large displacement amount does not occur, so that the reliability of the detection means 1005 improves.

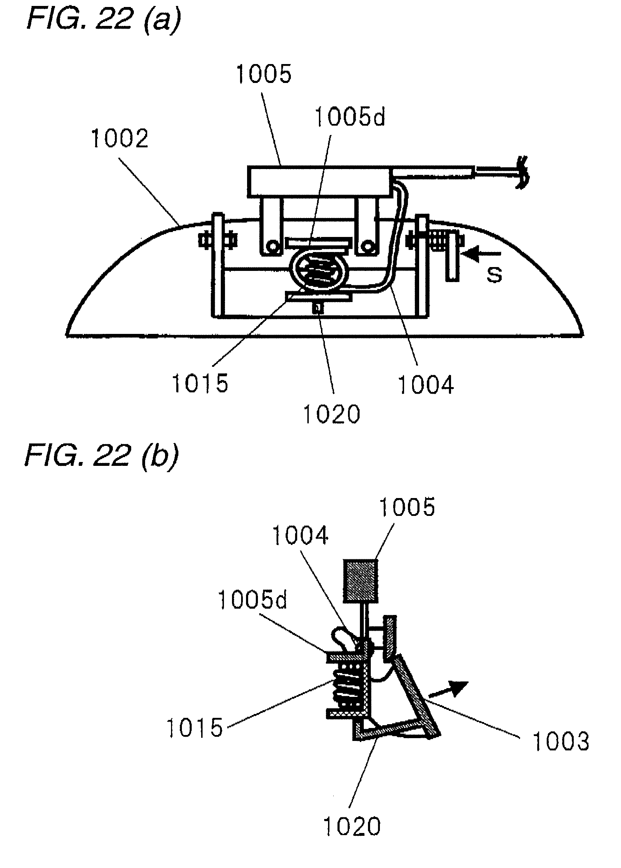

FIG. 22 (a) is a drawing to describe another attachment structure of the embodiment and (b) is a schematic drawing of viewing FIG. 20 (a) from S direction. A contract detector is provided so as to be operatively associated with a different moving part from the moving part in the fifth embodiment, operating together with the handle of the handle bracket. As shown here, the installation flexibility of the contact detector is high, so that it can also be implemented according to another structure.

### (Sixth embodiment)

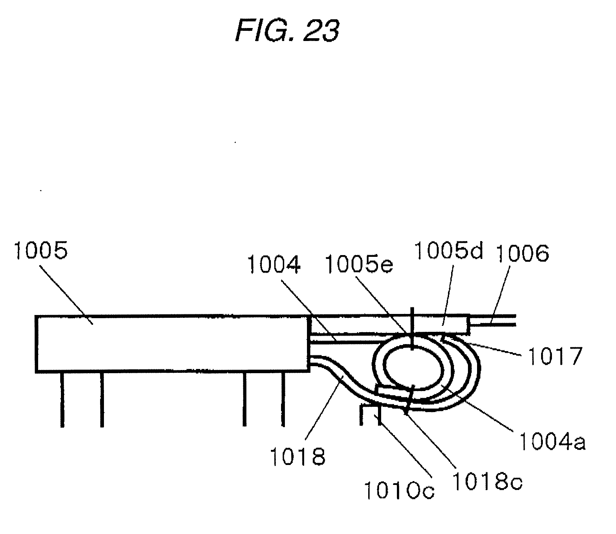

A sixth embodiment of the invention will be discussed with reference to FIG 23.

FIG. 23 is an enlarged external view of the main part of a handle bracket 1002 when it is viewed from the car inside in the sixth embodiment of the invention. The embodiment differs from the third to fifth embodiments in that support means 1018 is formed as a shape provided by bending a leaf spring of an elastic body roughly like a letter J having a curvature part at the tip and bringing the curvature tip 1017 into a guide part 1005d of position regulation means and rotating it 90 degrees, so that the support means 1018 is pressed against an upper end 1010c of an arm part 1010 by elasticity of the leaf spring, as shown in FIG. 23.

According to the configuration, as position regulation means of a piezoelectric sensor 1004, the guide part 1005d and a support part 1005e are fixed to detection means 1005, the support means 1018 is formed of the elastic body, and a multilayer superposition part 1009 is deformed with displacement of a moving part. Thus, when a door handle 1003 is unused, a moving part 1018c of the support means 1018 is urged under a predetermined pressure and is in contact with the upper end of the arm part 1010, so that when the opening operation of the door handle 1003 is performed, at the upper end of the arm part 1010, the support means 1018 and the piezoelectric sensor 1004 displace following displacement of the door handle 1003 and the detection means 1005 outputs an open detection signal in response to the deformation of the piezoelectric sensor 1004. Accordingly, pressure can be given for urging with the elasticity of the support means 1018 so that the moving part 1018c is easy to displace if a person comes in contact with the contact target, so that it is made possible to perform stable operation independently of the elasticity of the piezoelectric sensor 1004 and contact detection of a person or an object based on detection of minute displacement can be made with good responsibility and with higher sensitivity and higher output and the reliability can be improved. After predetermined displacement, the support means 1018 does not displace and the piezoelectric sensor 1004 also remains deformed and thus a break in the piezoelectric sensor 1004 because of too large displacement amount does not occur, so that the reliability of the detection means 1005 improves.

### (Seventh embodiment)

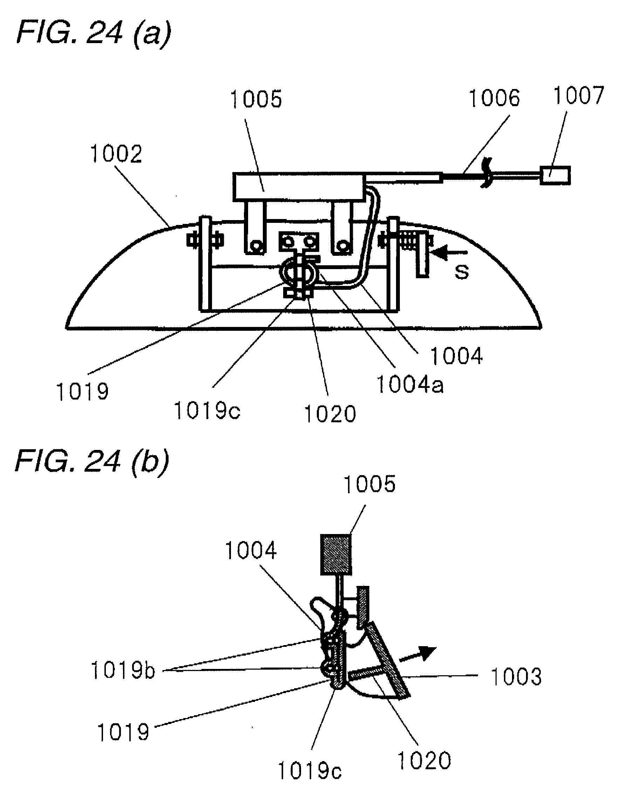

A seventh embodiment of the invention will be discussed with reference to FIG. 24.

FIG 24 (a) is an enlarged external view of a handle bracket 1002 when it is viewed from the car inside in the seventh embodiment of the invention and FIG. 24 (b) is a schematic drawing of viewing FIG. 24 (a) from S direction. The embodiment differs from the third to sixth embodiments in that a piezoelectric sensor 1004 turned to form a multilayer superposition part 1009 is sandwiched between two support parts 1019b from the top and bottom of the turn plane by support means 1019 made of a leaf spring, the support means 1019 is fixed like a cantilever, and an arm 1020 extended from a door handle displaces, whereby a moving part 1019c displaces in a direction of bending the turn plane.

According to the configuration, unlike the configuration wherein the simultaneous deformation part becomes deformed as the turn curvature radius of the bend part 1004a in the third embodiment increases or decreases, a plurality of bend parts 1004a become deformed in a direction in which the turn plane of the piezoelectric sensor 1004 bends as an arm 1020 displaces. Accordingly, as displacement of the moving part 1019c is detected, when minute displacement at the contact time of a person or an object is detected, it is detected according to simultaneous deformation of a plurality of parts of the piezoelectric sensor. Thus, when the same displacement is, received, if the number of bend points is large, the charge generation amount based on the piezoelectric effect increases according to the number of the bend points and an output signal can be taken larger, so that the sensitivity of the piezoelectric sensor 1004 improves and detection with higher sensitivity and higher output is made possible. Therefore, sufficient signal output is obtained as a person simply touches the contact detection target, and it is made possible to detect touch on the contact detection target. When the sensitivity of the piezoelectric sensor 1004 improves, for example, the amplification factor of signal processing can also be decreased in signal processing means installed in detection means 1005, so that the effect of electric noise can be decreased and the installation number of amplifiers of operational amplifiers, etc., can be reduced and miniaturization of the unit is also made possible. Since an electrode need not be exposed, the effect of disturbance and deposited dust, rain, snow, etc., is hard to receive. Further, cable-like piezoelectric sensor can become flexibly deformed and thus the number of restrictions on the installation place is small and the placement space also lessens.

In the embodiment, to turn the piezoelectric sensor 1004 at the bend part 1004a, the sequential stack structure is adopted so as to make the winding shape of the piezoelectric sensor 1004 the same shape. However, for example, the piezoelectric sensor 1004 may be turned spirally like a mosquito-repellent incense to form the bend part 1004a or the piezoelectric sensor 1004 may be turned like a spherical surface from various directions as when a traditional Japanese handball is made to form the bend part 1004a for forming the multilayer superposition part 1009 or the piezoelectric sensor 1004 may be meandered to form a simultaneous deformation part having a plurality of bend parts 1004a. Simultaneous deformation part A of the piezoelectric sensor 1004 need not necessarily be provided in the bend part 1004a; for example, if it is meandered, the piezoelectric sensor 1004 may be disposed so that a plurality of lines of the piezoelectric sensor 1004 overlapped in parallel receive deformation at the same time, and if the deformation amount of the simultaneous deformation part increases, a similar effect can be provided.

### (Eighth embodiment)

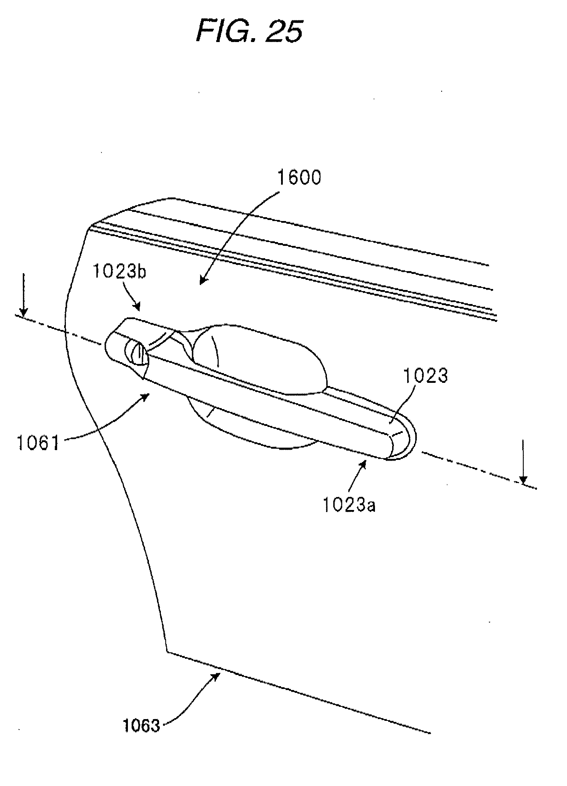

An eighth embodiment of the invention will be discussed with reference to FIGS. 25 to 30. In the description to follow, components identical with those described above are denoted by the same reference numerals and will not be discussed again. A door handle unit 1600 is attached to a vehicle door (door outer panel) 1063. A handle 1061 has a handle main body 1023 with support of one end side 1023a swingingly to the door 1063 through a support shaft 1021 and an opposite end side 1023b moved in the pulling direction by swinging. This means that the handle 1061 called pull rise type, grip type, or grab type with one side as a hinge is formed.

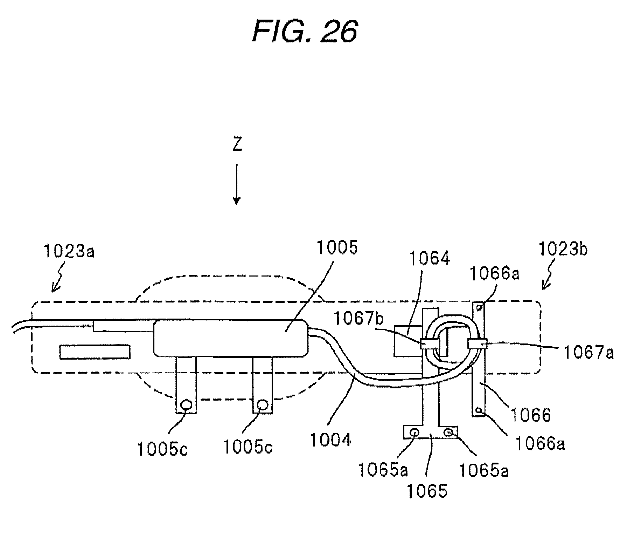

FIG. 26 is a schematic configuration drawing of the inside of the handle 1061. In the figure, a cable-like piezoelectric sensor 1004 having flexibility is placed in a handle bracket together with detection means 1005 and is fixed to the outer panel 1063. The piezoelectric sensor 1004 is formed like a turn shape (wind shape) so as to have a plurality of bend parts of simultaneous deformation part with binding bands 1067a and 1067b. A part of the turn shape portion (wind shape portion) is fixed to a position regulation part 1066 and the opposite side of the wind shape is fixed integrally to a moving part of a support part 1065 so as to move in conjunction with an arm part 1064 of the handle through the support part 1065 made of a leaf spring. The detection means 1005 is fixed in the bracket by a fix part 1005c and likewise the position regulation part 1066 is fixed in the bracket by a fix part 1066a and the support part 1065 is fixed in the bracket like a cantilever by a fix part 1065a so that the portion of the support part 1065 for coming in contact with the arm part 1064 becomes the moving part. Thus, only a part of the turn portion of the piezoelectric sensor is fixed and others are fixed in a loose fit state having a play portion.

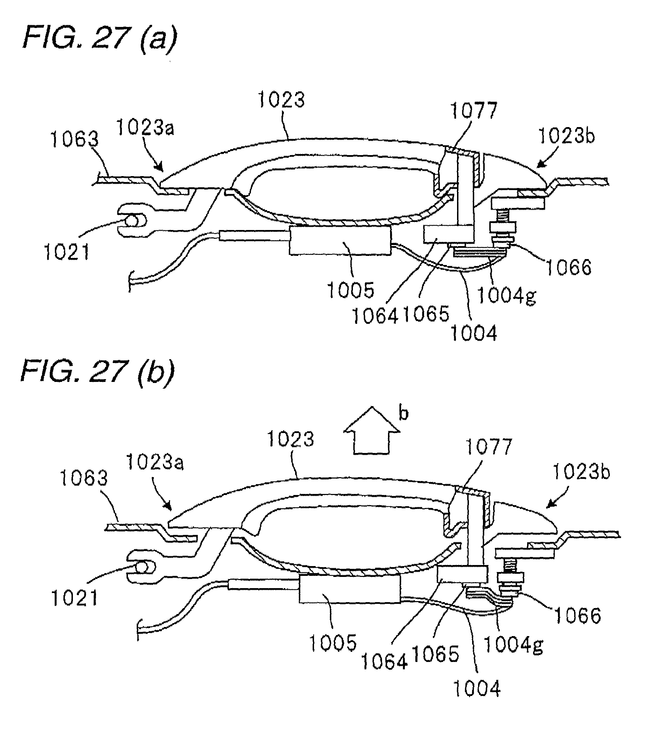

FIG. 27 (a) is a drawing of viewing the eighth embodiment from z direction in FIG. 26 when the handle is at a usual position. FIG. 27 (b) is a drawing of viewing the eighth embodiment from z direction in FIG. 26 when the handle is pulled in front b direction. As shown in FIGS. 27 (a) and (b), a wind shape portion 1004g of the piezoelectric sensor 1004 is pulled in conjunction with displacement of the arm 1064 before and after the operation and thus is deformed in the direction in which the turn plane bends.

According to the configuration, when minute displacement at the contact time of a person or an object is detected, a plurality of bend parts formed in the wind shape portion of the piezoelectric sensor 1004 also become deformed at the same time with displacement of the arm, so that detection with high sensitivity and high output is made possible.

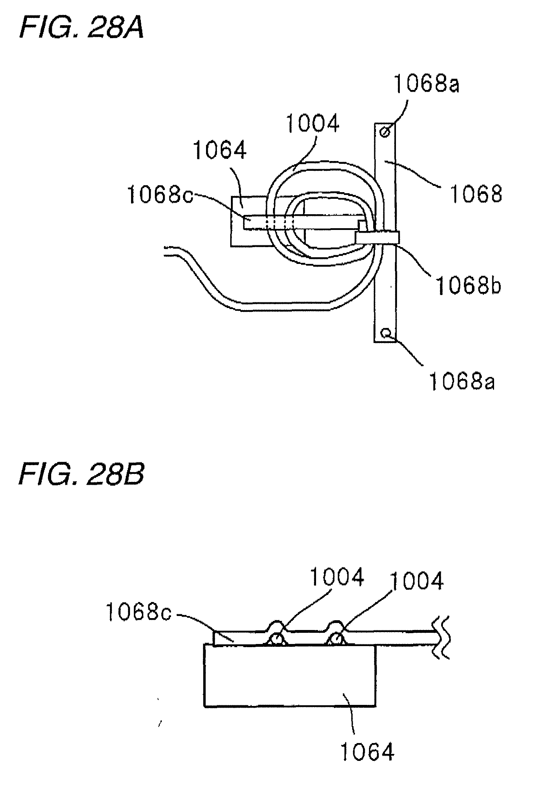

As shown in FIG. 28A, the wind shape portion of the piezoelectric sensor 1004 may be shaped having a bend part by turning spirally like a mosquito-repellent incense. The piezoelectric sensor 1004 is fixed with a binding band 1068b in a part of a support part 1068. On the other hand, the piezoelectric sensor 1004 is pressed and fixed at two points so as not to overlap in a convex part 1068c of the support part 1068 as shown in FIG. 28B. The support part 1068 is fixed to the outer panel 1063 through the bracket by a fix part 1068a.

According to the configuration, to form the wind shape portion, the portion of the piezoelectric sensor 1004 to be fixed with the binding band, etc., may be small, so that the formed wind shape portion has high flexibility, the bend part also becomes deformed flexibly in conjunction with change in the arm, detection with high sensitivity and high output is made possible.

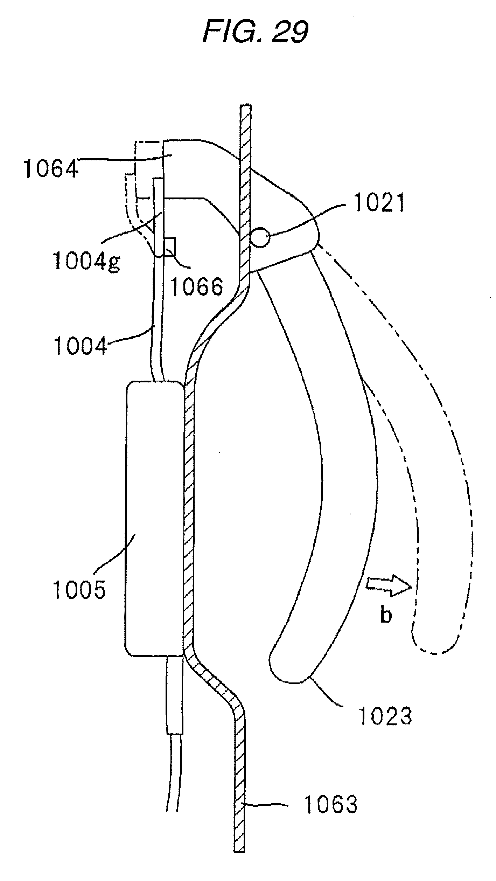

A similar configuration may be provided in a handle as shown in FIG. 29, FIG. 29 shows a state in which when a handle 1023 is pulled toward the user, the wind shape portion 1004g is pushed out to the arm 1064 and is deformed in the direction in which the turn plane of the wind shape portion 1004g bends. Thus, a plurality of bend parts formed in the wind shape portion of the piezoelectric sensor 1004 become deformed at the same time in conjunction with push out of the arm 1064, so that detection with high sensitivity and high output is made possible.

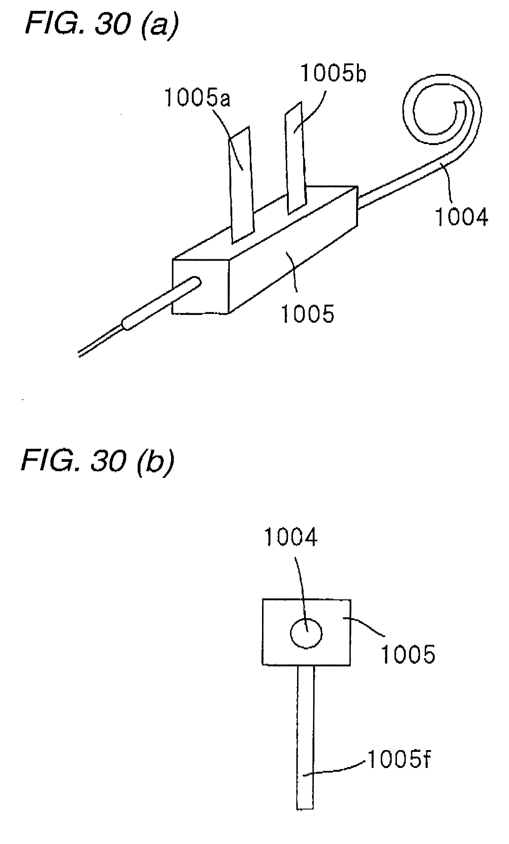

As shown in FIGS. 30(a) and 30(b), mounting brackets 1005a and 1005b of legs for fixing the detection means 1005 in the bracket may be provided at symmetrical positions at the center in the thickness direction of the main body of the detection means 1005. According to the configuration, to attach a detection means unit including the piezoelectric sensor 1004 and the detection means 1005 to the bracket, it can be attached to the driving seat side or the passenger seat side regardless of the orientation of the detection means unit.

An automobile with the door handle unit of the above-described embodiment applied to a smart entry system in doors of a side door, a tail gate, etc., and a building with the door handle unit applied to a smart entry system in doors of a front door, etc., can be provided.

In the smart entry system of an automobile, etc., a capacitance type sensor for detecting contact with a handle is provided in a handle grip because of the characteristic of the sensor. On the other hand, an antenna for transmitting a transmission-reception code may be installed in a hollow structure part in a handle grip considering ease and accuracy of external communications, in which case it is necessary to design so as to house the antenna and the sensor in the grip having only a limited space.

In the embodiment, a part of the contact detection sensor is fixed in the bracket rather than in the handle grip, so that the antenna and the sensor may be installed separately and the flexibility of the design increases.

Any other machine may be controlled in various manners based on an output signal of the door handle unit of the above-described embodiment, For example, the door handle unit of the above-described embodiment may be disposed in a power slide door or a power hatch back door of an automobile or a door such as an automatic door of a building and doorknob operation may be detected for controlling automatic opening and closing of the door; convenience improves. At this time, using the fact that the polarity of the output signal of the piezoelectric sensor 1004 becomes opposite when the door handle 1003 is pulled from the outside of the car and when the door handle 1003 is pushed as mentioned in the description of the operation of the embodiment, door opening/closing control may be performed based on the polarity of the output signal of the piezoelectric sensor 1004, for example, in such a manner that when the door handle 1003 is pulled from the outside of the car, the door is opened and that the door handle 1003 is pushed from the outside of the car, the door is closed.

The door opening/closing speed may be controlled in response to the magnitude of the output signal of the piezoelectric sensor 1004. For example, according to a configuration wherein the larger the output signal of the piezoelectric sensor 1004, the higher the door opening/closing speed, if the user wants to open or close a door quickly, he or she may operate the door handle 1003 strongly for increasing the output signal from the piezoelectric sensor 1004; convenience improves.

In addition, the door handle unit can be applied to control of various machines in such a manner that a power window is opened and closed, that illumination is turned on and off and is dimmed, or that an AV machine is turned on and off based on an output signal of the door handle unit.

While the invention has been described in detail with reference to the specific embodiments, it will be obvious to those skilled in the art that various changes and modifications can be made without departing from the spirit and the scope of the invention.
This application is based on Japanese Patent Application No. 2005-116829 filed on April 14, 2005, Japanese Patent Application No. 2005-319042 filed on November 2, 2005, Japanese Patent Application No. 2006-022051 filed on January 31, 2006, and Japanese Patent Application No. 2006-089002 filed on March 28, 2006, which are incorporated herein by reference.

### Industrial Applicability

As described above, in the door handle unit according to the invention, it is made possible for the piezoelectric sensor to have flexibility and be added to the door handle and it is made possible to detect minute displacement of the door handle with high sensitivity. Therefore, sufficient signal output is obtained as a person simply touches the door handle, and it is made possible to detect touch on the door handle. Thus, for example, the door handle unit can also be applied as a highly sensitive switch over various fields other than the door, so that it is made possible to apply the door handle unit to a handle member of a door to allow a substance to be taken in and out or to allow a human body to come and go.

## Claims

1. A contact detector comprising:
support means having a moving part displacing upon reception of contact;
a piezoelectric sensor having a part supported by said support means and becoming deformed in conjunction with displacement of the moving part; and
signal processing means for performing signal processing of output of said piezoelectric sensor,
wherein said piezoelectric sensor has a bend part to form a plurality of simultaneous deformation parts and the simultaneous deformation parts become deformed in conjunction with the moving part, whereby contact is detected.

2. The contact detector as claimed in claim 1, wherein the displacement amount of the moving part of said support means has a predetermined upper limit value, and
if the displacement of the moving part becomes the predetermined upper limit value or more, displacement is suppressed.

3. The contact detector as claimed in claim 1 or 2, wherein said support means and said piezoelectric sensor are fixed by said signal processing means,

4. The contact detector as claimed in any one of claims 1 to 3 further comprising position regulation means of said piezoelectric sensor,
wherein the moving part of the support means is provided with joint means made of an elastic body, whereby the moving part and the position regulation means are joined with elasticity and the simultaneous deformation parts are deformed with displacement of the moving part.

5. The contact detector as claimed in any one of claims 1 to 3, wherein said support means is made of an elastic body and the simultaneous deformation parts are supported by the moving part, whereby the simultaneous deformation parts are deformed with displacement of the moving part.

6. The contact detector as claimed in claim 5, wherein said support means has a fix part fixed at one end to a sensor unit comprising said support means, said piezoelectric sensor, and said signal processing means, is molded roughly like a plate shaped like a cantilever, and supports a part of said piezoelectric sensor in an extension direction to an opposite side to the fix part.

7. The contact detector as claimed in claim 6, wherein said piezoelectric sensor comprises the simultaneous deformation parts in the extension direction to the opposite side to the fix part.

8. The contact detector as claimed in claim 7, wherein said signal processing means detects a signal of said piezoelectric sensor at the deformation time from a state in which said support means is urged under a predetermined stress.

9. The contact detector as claimed in any one of claims 1 to 8, wherein the simultaneous deformation parts are formed by turning said piezoelectric sensor at least one or more.

10. The contact detector as claimed in any one of claims 1 to 9, wherein the simultaneous deformation parts are formed by forming one piezoelectric sensor with a multilayer superposition part.

11. The contact detector as claimed in claim 9 or 10, wherein the multilayer superposition part of said piezoelectric sensor is supported loosely.

12. The contact detector as claimed in any one of claims 1 to 11, wherein said piezoelectric sensor comprises a center electrode, a piezoelectric body, an outer electrode, and a coating layer with them coaxially formed in order and the outer electrode is formed of a braided metal wire.

13. The contact detector as claimed in any one of claims 1 to 12, wherein said piezoelectric sensor is of an eccentric structure wherein a center electrode is eccentric relative to a piezoelectric body, and is bent in a specific direction relative to the eccentric direction to form the simultaneous deformation parts.

14. The contact detector as claimed in claim 13, wherein said piezoelectric sensor is rectangular in cross section as the cross-sectional shape of the outer shape.

15. A door handle unit comprising a contact detector as claimed in any one of claims 1 to 14, wherein a moving arm of a door handle is brought into contact with the moving part of the support means for attachment,

16. The door handle unit as claimed in claim 15 further comprising a connection part for connecting the moving arm of the door handle and the moving part of the support means, wherein the connection state of the moving arm and the moving part is maintained by the connection part at least in the early stage of displacement of the moving arm in operation of the door handle.

17. A smart entry system comprising the door handle unit as claimed in claim 15 or 16.
